(19) Europäisches Patentamt
European Patent Office
Office européen des brevets

(11) EP 1 666 988 A1

(12) **EUROPEAN PATENT APPLICATION**
published in accordance with Art. 158(3) EPC

(43) Date of publication:
**07.06.2006 Bulletin 2006/23**

(21) Application number: **04773235.9**

(22) Date of filing: **10.09.2004**

(51) Int Cl.:
***G03H 1/02*** *(1974.07)* ***C08G 18/06*** *(1974.07)*

(86) International application number:
**PCT/JP2004/013591**

(87) International publication number:
**WO 2005/029201 (31.03.2005 Gazette 2005/13)**

(84) Designated Contracting States:
**DE DK FR GB HU SE**

(30) Priority: **17.09.2003 JP 2003323809**
**27.11.2003 JP 2003396737**
**03.03.2004 JP 2004058640**
**15.03.2004 JP 2004072139**

(71) Applicant: **Konica Minolta Medical & Graphic, Inc.**
**Tokyo 163-0512 (JP)**

(72) Inventor: **TAKEYAMA, T.;**
**c/o Konica Minolta M. & G., Inc.**
**Hino-shi, Tokyo 191-8511 (JP)**

(74) Representative: **McCluskie, Gail Wilson**
**J.A. Kemp & Co.,**
**14 South Square,**
**Gray's Inn**
**London WC1R 5JJ (GB)**

(54) **HOLOGRAPHIC RECORDING MEDIUM, HOLOGRAPHIC RECORDING METHOD, AND HOLOGRAPHIC INFORMATION MEDIUM**

(57) In a holographic recording medium in which a holographic recording medium is sandwiched between the first base material and a second base material, the holographic recording medium is **characterized in that** the holographic recording layer contains a binder forming compound, a compound provided with an ethylenical unsaturated bond, a photopolymerization initiator which can initiates a polymerization reaction of the compound provided with an ethilenical unsaturated bond, the content of the compound provided with an ethilenical unsaturated bond is within a range of 1 to 50 % by mass for the whole of the composition and the photopolymerization initiator contains at least a composition represented by the following general formula (1).

$$[A\text{-}Fe\text{-}B]^{+} \cdot X^{-}$$

With above structure, it is possible to provide a holographic recording medium having a high sensitivity and superior in storage, a holographic recording method, and a holographic recording medium recorded with holographic information.

FIG. 1

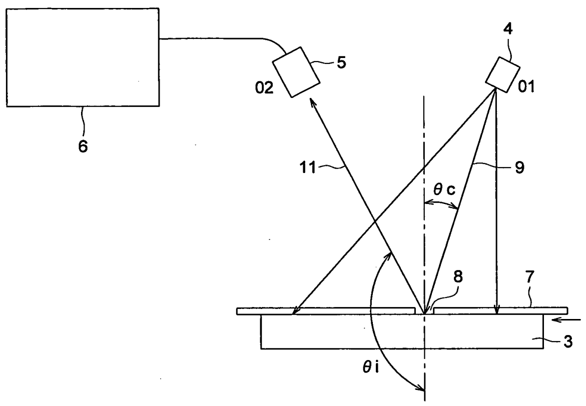


EP 1 666 988 A1

## Description

### TECHNICAL FIELD

The present invention relates to a holographic recording medium that can be of a large capacity and can make high speed transfer possible, and further to a holographic recording method and to a holographic information medium on which information is recorded holographically.

### BACKGROUND ART

In recent years, high-speed exchanges of data in a large volume have been increased by the spread of Internet and by a shift to the broadband system, and a volume of data stored in each affiliated organ has been expanded rapidly because of extension of e-governments caused by promotion of the government of each country. In addition, recording media each having high storage capacity are expected to be needed in the future, by the spread of a high-definition television in a TV broadcast and by the spread of a digital terrestrial broadcast, and among them, next-generation optical recording media such as a blu-ray disc and a HDDVD disc are estimated to spread in the future. With respect to the next but one generation recording media, however, main products are absent, although various systems are proposed.

Among the next but one generation recording media, a memory system of a page type, especially, holographic recording is proposed to take the place of a conventional memory device, and it is watched with keen interest recently, because it has a high storage capacity and is of the system which makes random access and high speed transfer possible. With respect to this holographic recording, detailed explanations are described in some introductions (such as, for example, "Holographic Data Storage (Springer Series in Optical Sciences, Vol. 76)" written by Hans J. Coufal and others (Springer-Verlag GmbH & Co. KG, August in 2000)).

As a recording system in the holographic recording, a recording method using a holographic recording medium wherein transparent materials are arranged respectively on both sides of a holographic recording layer (for example, U. S. Patent No.5,719,691) and a recording method using a holographic recording medium equipped with a reflection surface arranged on one side of a holographic recording layer (for example, TOKKAI No. 2002-123949) are proposed.

In the basic principle of the holographic recording medium of this kind, the refractive index in a holographic recording layer in the medium is changed to record information by giving holographic exposure, and the change of the refractive index recorded in the medium is read to regenerate information, and there are proposed various materials as a material for the holographic recording layer, including the material using an inorganic material (for example, British Patent No. 9,929,953), the material using a compound that shows structural isomer with light (for example, TOKKAIHEI No. 10-340479), or the material using diffusion polymerization of photopolymer (for example, U. S. Patent No. 4,942,112). Among these, in the material using photopolymer described in Patent Document 5, a volatile solvent is used in the case of manufacturing a composition for forming a recording layer, and therefore, the maximum thickness of the recording layer is limited to about 150 $\mu$m. In addition, volume shrinkage of 4 - 10% caused by polymerization has affected adversely the reliability in the case of regenerating recorded information.

There are proposed a composition for forming a holographic recording layer utilizing cation polymerization wherein no solvent is used and organization shrinkage is relatively less (for example, U. S. Patent No. 5,759,721) and others, for improving the aforesaid weak points. However, the composition for forming a holographic recording layer has drawbacks wherein there is a fear that island-shaped portions formed, under the holographic exposure, by photo-polymerization of monomer in the recording layer are moved undesirably, and a volume of liquid substance is expanded by changes of ambient temperatures in the apparatus, because those other than monomer that causes photo-cation polymerization are liquid substances.

To improve these drawbacks, radical polymerization is used for recording in holographic exposure, and there is proposed a composition (for example, U. S. Patent No. 6,103,454) that forms a binder after forming a medium, for holding monomer that makes this radical polymerization before exposure to be possible, thus, it is possible to thicken a layer thickness of the holographic recording layer and to lessen the volume shrinkage by using the composition of this kind, which, however, is still insufficient.

On the other hand, when conducting holographic recording on a holographic recording medium, it is essential for raising a recording speed that exposure is given by low energy. For improving this recording speed, namely, the recording sensitivity, selection and combination of a monomer for diffusion polymerization, a compound for forming binder, a sensitizing dye and a radical initiator are important. For example, though there is proposed a photosensitive composition for holographic recording employing a binder having a high degree of polymerization in advance without using a compound for forming a binder (for example, World Publication No. 03/081344 Pamphlet), there has been a problem that a solvent is needed when adjusting a photosensitive composition for holographic recording, and a thickness of the recording layer is not sufficient.

## DISCLOSURE OF THE INVENTION

This invention has been made in view of the above problems, and an objective of this invention is to provide a holographic recording medium, a holographic recording method and a holographically recorded holographic information medium.

To achieve the above objective, an embodiment of this invention is;

(1) A holographic recording medium provided with a holographic recording layer containing a binder forming compound, a compound provided with an ethylenical unsaturated bond, a photopolymerization initiator which can initiates a polymerization reaction of said compound provided with an ethilenical unsaturated bond, and a sensitizing dye which can spectrally sensitize a photopolymerization initiator, wherein said binder forming compound contains at least one compound combination selected from following (1) - (8):

(1) a compound provided with an isocyanate group and a compound provided with a hydroxyl group,
(2) a compound provided with an isocyanate group and a compound provided with an amino group,
(3) a compound provided with a carbodiimido group and a compound provided with a carboxyl group,
(4) a compound provided with an unsaturated ester group and a compound provided with an amino group,
(5) a compound provided with an unsaturated ester group and a compound provided with a mercaptan group,
(6) a compound provided with a vinyl group and a compound provided with a silicon hydride group,
(7) a compound provided with an oxirane group and a compound provided with a mercaptan group,
(8) a compound provided with a group selected from oxirane, oxetane, tetrahydrofuran, oxepane, monocyclic actal, bicyclic acetal, lactone, cyclic orthoester and cyclic carbonato in the molecule, and a thermal cationic polymerization initiator;

the content of said compound containing an ethylenical unsaturated compound is 1 - 50 weight% based on the whole composition; and said photopolymerization initiator includes at least a compound represented by following general formula (1).

$[A\text{-}Fe\text{-}B]^+ \cdot X^-$ General formula (1)

(wherein, A represents an unsubstituted or alkyl substituted cyclopentadienyl group, B represents an unsubstituted or substituted allene group and $X^-$ represents a counter anion containing a fluorine atom.)

(2) In the invention, the holographic recording medium described in above item (1) is characterized in that the aforesaid binder forming compound contains aforesaid compound combination (1) a compound provided with an isocyanate group and a compound provided with a hydroxyl group, or aforesaid (7) a compound provided with an oxirane group and a compound provided with a mercaptan group.

(3) In the invention, the holographic recording medium described in above item (1) is characterized in that the aforesaid binder forming compound contains aforesaid compound combination (1) a compound provided with an isocyanate group and a compound provided with a hydroxyl group, and said compound provided with an isocyanate group contains three or more isocyanate groups so as to make a content of 30 - 65 weight% in the compound.

(4) In the invention, the holographic recording medium described in above item (3) is characterized in that the aforesaid compound provided with an isocyanate group contains 5 - 100 weight% of the compound containing three or more isocyanate groups so as to make a content of 30 - 65 weight% in the compound.

(5) In the invention, the holographic recording medium described in above item (3) is characterized in that the molecular weight of the aforesaid compound provided with an isocyanate group is 200 - 500.

(6) In the invention, the holographic recording medium described in above item (3) is characterized in that the aforesaid compound provided with a hydroxyl group is a compound containing two or more hydroxyl groups in the molecule having a molecular weight of 100 - 2000.

(7) In the invention, the holographic recording medium described in above item (1) is characterized by including a compound containing a (meth)acryloyl group in the molecule as the aforesaid compound provided with an ethylenic unsaturated bond.

(8) In the invention, the holographic recording medium described in above item (1) is characterized by containing a compound provided with a refractive index of at least 1.55 at 50 - 100 weight% based on the whole compound as the aforesaid compound provided with an ethylenic unsaturated bond.

(9) In the invention, the holographic recording medium described in above item (1) is characterized in that Dh is 200 μm- 2.0 mm, and relationships of $0.15 \le Dh/(D1 + D2) \le 2.0$ and $D1 \le D2$ are satisfied when a thickness of the aforesaid first substrate is D1, a thickness of the aforesaid second substrate is D2 and a thickness of the aforesaid holographic recording layer is Dh.

(10) In the invention, the holographic recording medium described in above item (1) is characterized in that the aforesaid first substrate is transparent and is provided with an anti-reflection treatment on the plane opposite to the plane contacting with a holographic recording layer.

(11) In the invention, the holographic recording medium described in above item (1) is characterized in that a material of the aforesaid first substrate is glass.

(12) In the invention, the holographic recording medium described in above item (1) is characterized in that the aforesaid second substrate is accumulated with a reflective layer having a reflectance of not less than 70%.

(13) In the invention, the holographic recording medium described in above item (1) is characterized in that the shape of said holographic recording medium is a disk-form or a card-form.

(14) Further, an embodiment of the invention is a holographic recording method to record on the holographic recording medium described in above item (1), wherein information is recorded as follows: after reacting a binder forming compound to form a binder before the aforesaid holographic recording medium is holographically exposed, holographic exposure is performed by making information light and reference light incident from the first substrate side based on information to be recorded, resulting in photopolymerization initiator being activated, and a compound provided with an ethylenic unsaturated bond is diffusion polymerized by this active species in a holographic recording layer.

(15) In the invention, the holographic recording method described in item (14) is characterized in that a recording medium is stabilized by heat and light irradiation on the whole recording medium after information recording on the holographic recording medium has been finished.

(16) Further, an embodiment of the invention is a method to record on the holographic recording medium described in above item (1), wherein information is recorded as follows: holographic exposure is performed by making information light and reference light incident from the first substrate side based on information to be recorded, resulting in activation of photopolymerization initiator, a compound provided with an ethylenic unsaturated bond is diffusion polymerized by this active species in a holographic recording layer, and the recording medium is stabilized by heat and light irradiation on the whole recording medium after information recording on the holographic recording medium has been finished.

(17) Further, an embodiment of the invention is a holographic information medium in which a holographic information recording layer, where information is recorded on a holographic recording layer, is accumulated, wherein said holographic information recording layer is provided with a region comprising a binder formed from said binder forming compound and a region primarily comprising a radical polymerization product formed by radical polymerization containing an ethylenic unsaturated bond as a monomer unit formed by radical polymerization.

## BRIEF DESCRIPTION OF THE DRAWINGS

Fig. 1: a schematic diagram showing the principle of a measurement device utilized for measuring a shrinkage rate.

## BEST MODE FOR CARRYING OUT THE INVENTION

In the following, a holographic recording medium, a holographic recording method and a holographic information medium will be detailed.

A holographic recording medium of this invention is one in which a holographic recording layer is sandwiched between the first substrate and the second substrate, wherein said holographic recording layer contains at least one type of a binder forming compound selected from, a compound provided with an isocyanate group and a compound provided with a hydroxyl group, a compound provided with an isocyanate group and a compound provided with an amino group, a compound provided with a carbodiimido group and a compound provided with a carboxyl group, a compound provided with an unsaturated ester group and a compound provided with an amino group, a compound provided with an unsaturated ester group and a compound provided with a mercaptan group, a compound provided with a vinyl group and a compound provided with a silicon hydride group, a compound provided with an oxirane group and a compound provided with a mercaptan group, a compound provided with a group selected from oxirane, oxetane, tetrahydrofuran, oxepane, monocyclic actal, bicyclic acetal, lactone, cyclic orthoester and cyclic carbonato in the molecule and a thermal cationic polymerization initiator, a compound provided with an ethylenic unsaturated bond and a photopolymerization initiator which can initiate polymerization reaction of aforesaid compound provided with an ethylenic unsaturated bond, and the content of the aforesaid compound provided with an ethylenic unsaturated bond is in a range of 1 - 50 weight% based on the total composition as well as the aforesaid photopolymerization initiator which can initiate polymerization reaction of the aforesaid compound provided with an ethylenic unsaturated bond includes at least a compound represented by general formula (1). Herein, a binder forming compound means a precursor which is not a polymer as a binder

at the time of preparation of a recording composition, and utilizing such a binder forming compound enables to prevent shrinkage of a recording medium before and after holographic exposure, which will be detailed later, as well as to make the thickness of a recording layer at the time of preparing a holographic recording medium thicker.

A binder forming compound of this invention is characterized in that binder forming compounds each other do not polymerize or cross-link at the time of preparing a holographic recording composition but the binder forming compound is converted into a binder by polymerization or cross-linking at the time of preparing a holographic recording medium described below or after holographic exposure. As such a binder forming compound, utilized can be at least one combination by appropriately selecting from a compound provided with an isocyanate group and a compound provided with a hydroxyl group, a compound provided with an isocyanate group and a compound provided with an amino group, a compound provided with a carbodiimido group and a compound provided with a carboxyl group, a compound provided with an unsaturated ester group and a compound provided with an amino group, a compound provided with an unsaturated ester group and a compound provided with a mercaptan group, a compound provided with a vinyl group and a compound provided with a silicon hydride group, a compound provided with an oxirane group and a compound provided with a mercaptan group; a compound provided with a group selected from oxirane, oxetane, tetrahydrofuran, oxepane, monocyclic actal, bicyclic acetal, lactone, cyclic orthoester and cyclic carbonato in the molecule and a thermal cationic polymerization initiator, and more preferable among above selection is at least one type selected from a compound provided with an isocyanate group and a compound provided with a hydroxyl group, or a compound provided with an oxirane group and a compound provided with a mercaptan group, which can be polymerized or cross-linked to be a binder at a mild condition.

A compound provided with an isocyanate group, which is employed at the time of cross-linking a compound provided with an isocyanate group and a compound provided with a hydroxyl group, is not specifically limited, however, more preferable is a compound provided with two or more isocyanate groups in the molecule with respect to sufficiently hold a compound provided with an ethylenic unsaturated bond as a photopolymerization composition detailed above after preparation of a holographic recording medium, and further, since a holographic recording medium of this invention, which will be detailed later, is prepared by sandwiching a recording composition, which is a liquid at ordinary temperature or at a temperature of not higher than 100 °C, between two substrates at a predetermined thickness, more preferable is a compound which is a liquid at ordinary temperature or has a melting point of not higher than 100°C.

Specific examples of such a compound provided with an isocyanate group include such as 1,8-diisocyanate-4-isocyanatemethyl octane, 2-isocyanateethyl-2,6-diisocyanate caproate, benzene-1,3,5-triisocyanate, 1-methylbenzene-2,4,6-triisocyanate, 1,3,5-trimethylbenzene-2,4,6-triisocyanate, diphenylmethane-2,4,4'-triisocyanate, triphenylmethane-4,4',4''-triisocyanate, bis(isocyanatetolyl)phenylmethane, dimethylene disiocyanate, tetramethylene diisocyanate, hexamethylene diisocyanate, 2,2-dimethylpentane diisocyanate, 2,2,4-trimethylpentane diisocyanate, decane isocyanate, ω,ω'-disiocyanate-1,3-dimethylbenzene, ω,ω'-disiocyanate-1,2-dimethylcyclohexane diisocyanate, ω,ω'-disiocyanate-1,4-diethylbenzene, isophorone diisocyanate, 1-methylhexyl-2,4-diisocyanate, ω,ω'-disiocyanate-1,5-dimethylnaphthalene, ω,ω'-disiocyanate-n-propylbiphenyl, 1,3-phenylene diisocyanate, 1-methylbenzene-2,4-diisocyanate, 1,3-dimethylbenzene-2,6-diisocyanate, naphthalene-1,4-diisocyanate, 1,1'-dinaphthyl-2,2'-diisosianate, biphenyl-2,4-diisocyanate, 3,3'-dimethylbiphenyl-4,4'-diisocyanate, diphenylmethane-4,4'-diisocyanate, 2,2'-dimethyldiphenylmethane-4,4'diisocyanate, dicyclohexylmethane-4,4'-diisocyanate, 3,3'-dimethoxydiphenylmethane-4,4'-diisocyanate, 4,4'-diethoxydiphenylmethane-4,4'-diisocyanate, tolylene diisocyanate, 1,5-naphthylene diisocyanate, xylylene diisocyanate and tetramethlenexylylene diisocyanate, in addition to these, a dimmer, a trimer or an adduct of each above-described isocyanate (such as a 2-mol-adduct of hexamehylene diisocyanate, a 3-mol-adduct of hexamehylene diisocyanate, a 2-mol-adduct of 2,4-tolylene diisocyanate and a 3-mol-adduct of 2,4-tolylenediisocyanate), an adduct of two or more types of isocyanates being different to each other selected from these isocyanates and adducts (such as an adduct of tolylene diisocyanate and trimethylol propane and an adduct of hexamethylene diisocyanate and trimethylol propane) of these isocyanates and dihydric or trihydric polyalcohols (such as diethylene glycol, polyethylene glycol, dipropylene glycol, polypropylene glycol, polytetramethylene glycol and trimethylol propane). These isocyanate compounds may be utilized alone or in combination of two or more types.

Further, it is more preferable to utilize an isocyanate compound provided with at least three isocyanate groups in the molecule and has an occupying ratio of an isocyanate group of 30 - 65 weight% in the compound, because prevented can be shrinkage of a holographic recording medium before and after holographic exposure which will be detailed later.

Isocyanate compounds provided with at least three isocyanate groups in the molecule and having an occupying ratio of an isocyanate group of 30 - 65 weight% in the compound can be utilized without specific limitation provided that the compounds satisfies this condition, and include such as 1,8-diisocyanate-4-isocyanatemethyl-octane (NCO content: 50.2 weight%, molecular weight: 251.3), 2-isocyanatethyl-2,6-diisocyanate caproate (NCO content: 49.8 weight%, molecular weight: 253.2), benzene-1,3,5-triisocyanate (NCO content: 62.7 weight%, molecular weight: 201.1), 1-methylbenzene-2,4,6-triisocyanate (NCO content: 58.6 weight%, molecular weight: 215.2), 1,3,5-trimethylbenzene-2,4,6-triisocyanate (NCO content: 51.8 weight%, molecular weight: 243.2), diphenylmethane-2,4,4'-triisocyanate (NCO content:

43.3 weight%, molecular weight: 291.3), triphenylmethane-4,4',4"-triisocyanate (NCO content: 34.3 weight%, molecular weight: 367.4) and bis(isocyanatetolyl)phenylmethane (NCO content: 42.6 weight%, molecular weight: 291.3).

Herein, with respect to the isocyanate compounds described above, a holographic information medium, which is utilized in a state of finishing recording of whole information on a holographic recording medium, in which a recording layer comprising a holographic recording composition, detailed later is accumulated, is possibly exposed to variety of environmental temperatures at which the holographic information medium is placed under a fluorescent lamp or by the window or is allowed to stand similar to such as a CD and a DV. Therefore, preferable are those to depress coloration of a recording layer under variety of conditions, and aliphatic isocyanate compounds among the above compounds are more preferable to depress such coloration.

In this invention, a binder may be formed by self-cross-linking of the compound provided with an isocyanate group as an essential component described above, however, it is preferable to form a binder by a cross-linking reaction of an isocyanate group of the isocyanate compound detailed above and a compound provided with an functional group which reacts with an isocyanate group in the molecule, and such compounds which can react with an isocyanate group include such as a compound provided with a hydroxyl group in the molecule, a compound provided with a primary or secondary amino group and a compound provided with an enamine form. However, a compound provided with a hydroxyl group is preferred, as a compound capable of reacting with an isocyanate compound, among the above compounds to depress coloration of a holographic information medium utilized in a state of finishing to record whole information on a holographic recording medium, in which a recording layer comprising a holographic recording composition which will be detailed later is accumulated, and more preferred is a compound provided with at least two aliphatic alcoholic hydroxyl groups in the molecule. Further, more preferable are compounds which are a liquid at ordinary temperature or have a melting point of not higher than 100 °C, because a holographic recording medium is prepared, as detailed later, by sandwiching a recording composition, which is a liquid at ordinary temperature or at not higher than 100 °C, between two substrates at a predetermined thickness.

Such compounds provided with at least two alcoholic hydroxyl groups in the molecule include such as diethylene glycol, triethylene glycol, polyethylene glycol, dipropylene glycol, tripropylene glycol, polypropylene glycol, 2,2-dimethyl-1,3-propanediol, 2,2-diethyl-1,3-propanediol, 2-butyl-2-ethyl-1,3-propanediol, 1,2-butanediol, 1,4-butanediol, polytetramethylene glycol, 1,5-pentanediol, 2-methyl-2,4-pentanediol, 3-methyl-1,5-pentanediol, 1,6-hexanediol, 2-ethyl-1,3-hexanediol, 2,5-dimethyl-2,5-hexanediol, 1,10-decanediol, 1,4-cyclohexanediol, glycerin, 1,2,6-hexanetriol, trimethylolethane, trimethylolpropane, pentaerythritol and sorbitol, in addition to these, alcohols in which the above-described compounds provided with at least two alcoholic hydroxyl groups in the molecule are modified with bihydric alcohols such as ethylene glycol, diethylene glycol, triethylene glycol, polyethylene glycol, propyrene glycol, dipropylene glycol, tripropylene glycol, polypropylene glycol and polytetramethylene glycol. Herein, these compounds provided with at least two alcoholic hydroxyl groups in the molecule may be utilized alone or in combination of two or more types.

The molecular weight of a compound provided with at least two aliphatic type alcoholic hydroxyl groups in the molecule is preferably 100 - 2000 taking into consideration volatility of the compound itself and compatibility or solubility with a compound provided with an ethylenic unsatulated bond, a compound provided with a functional group which can perform cationic polymerization or a photopolymerization initiator, and the addition amount of a compound provided with at least two aliphatic type alcoholic hydroxyl groups in the molecule cannot be defined ununequivocally with respect to the types and addition amount of an isocyanate compound as an essential component described above, however, is generally in a range of $0.5 \leq N/M \leq 2.0$ and more preferably $0.7 \leq N/M \leq 1.5$, when a mol number of isocyanate groups being present in a holographic recording composition of a compound provided with an isocyanate group is N [mol] and a mol number of hydroxyl groups being present in a holographic recording composition of the aforesaid compound provided with an alcoholic hydroxyl group is M [mol], with respect to compatibility and control of cross-linking reaction.

Further, in this invention, preferably added are a commonly known organometallic compounds of such as tin and lead as a urethane curing catalyst, in the case of intending to perform the reaction at low temperature when a urethane bond is formed by reacting the aforesaid compound provided with an isocyanate group and a compound provided with at least two alcoholic hydroxyl groups in the molecule.

Further, as a compound provided with an oxirane group in the molecule and a compound provided with a mercaptan group when a binder is formed by polymerizing a compound provided with an oxirane group and a compound provided with a mercaptan group, commonly known compounds capable of cross-linking can be utilized without limitation, however, a compound which is a liquid at ordinary temperature or has a melting point of not higher than 100 °C is preferred and a compound provided with at least two oxirane groups or mercaptan groups are more preferred, because at the time of preparation of a holographic recording medium of this invention, which will be detailed later, it is prepared by sandwiching a recording composition which is a liquid at ordinary temperature or has a melting point of not higher than 100 °C between two substrates at a predetermined thickness.

Specific compounds provided with an oxirane group described above include aliphatic polyglycidyl eter, polyalkylene glycol diglycidyl eter, tertiary carboxylic acid monoglycidyl eter; resins the ends of which are modified by a glycidyl group such as a polycondensation product of bisphenol A and epichlorohydrin, a polycondensation product of

hydrogenated bisphenol A and epichlorohydrin, a polycondensation product of brominated bisphenol A and epichlorohydrin, a polycondensation product of bisphenol F and epichlorohydrin; glycidyl modified phenol novolak resin and glycidyl modified o-cresol novolak resin, in addition to these, compounds described in "Chemical Product of 11290", published by Kagaku Kogyo Nippo-Sha, pp. 778 - 787, are also preferably utilized. Such compounds provided with an oxirane group in the molecule may be also appropriately utilized in combination of two or more types.

Further, compounds provided with a mercaptan group include such as thioglycollic acid, ammonium thioglycolate, monoethanolamine thioglycolate, soda thioglycolate, methylthioglycolate, octylthioglycolate, methoxybutyl thioglycolate, butandiol bisthioglycolate, ethyleneglycol bisthioglycolate, trimethylolpropane tristhioglycolate, pentaerythritol tetrakisthioglycolate, 3-mercaptopropionic acid, methyl mercaptopropionate, octyl mercaptopropionate, methoxybutyl mercaptopropionate, tridecyl mercaptopropionate, butanediol bisthiopropionate, ethyleneglycol bisthiopropionate, trimethylolpropane tristhiopropionate, pentaerythritol tetrakisthiopropionate and an ester of a polyhydric alcohol such as dipentaerythritol or trimethylolpropane and mercapto propionic acid. These thiol containing compounds may be utilized alone or in combination of two or more types.

Further, it is preferable to incorporate a Brøensted base or a Lewis base when a binder is formed by polymerizing a compound provided with an oxirane group and a compound provided with a mercaptan group, with respect to polymerization at milder conditions, and such bases include amine compounds such as pyridine, pyperidine, dimethylaniline, 2,4,6-tris(dimethylaminomethyl)benzene and 2,4,6-tris(dimethylamnomethyl)phenol.

Further, in the above described photopolymerization initiator represented by general formula (1), which is added in a recording layer as an essential component of this invention, an unsubstituted or alkyl substituted cyclopentadienyl group represented by A in the formula means a cyclopentadienyl group to which hydrogen or an alkyl group is bonded. Herein, the number of alkyl groups is 0 - 5 against a cyclopentadienyl group, and an alkyl group is preferably one having a straight chain, branched chain or cyclic form having a carbon number of 1 - 12. Further, an unsubstituted or substituted allene group represented by B in the formula means unsubstituted or substituted compounds provided with at least a benzene ring such as benzene, naphthalene, anthracene, phenanthrene, chrysene, pyrene, triphenylene, perylene or fluorene; substituents of said allene group represent alkyl groups having a straight chain, branched chain or cyclic form having a carbon number of 1 - 12, such as -OR, -COR and -COOR; and aforesaid R represents alkyl groups having a straight chain, branched chain or cyclic form having a carbon number of 1 - 12. Further, anions represented by $X^-$ in the formula include a halogen ion, nitrate ion, hexafluoroantimonate, hexafluorophosphate, triflate, tetrafluoroborate and pentafluorohydroxyantimonate.

Specific examples represented by general formula (1) include such as (η6-m-xylene) (η5-cyclopentadienyl) iron (1+) tetrafluoroborate, (η6-o-xylene)(η5-cyclopentadienyl)iron(1+) triflate, (η6-o-xylene) (η5-cyclopentadienyl) iron (1+) hexafluoroantimonate, (η6-p-xylenes) (η5-cyclopentadienyl) iron(1+) triflate, (η6-acetophenone) (η5-methylcyclopentadienyl)iron(1+) hexafluoroantimonate, (η6-xylenes (mixture of isomers)) (η5-cyclopentadienyl)iron(1+) hexafluoroantimonate, (η6-xylenes (mixture of isomers)) (η5-cyclopentadienyl) iron(1+) hexafluorophosphate, (η6-cumene) (η5-cyclopentadienyl)iron(1+) hexafluoroantimonate, (η6-cumene) (η5-cyclopentadienyl) iron(1+) hexafluorophosphate, (η6-cumene) (η5-cyclopentadienyl) iron(1+) hexafluoroarsenate, (η6-chrysene) (η5-cyclopentadienyl) iron(1+) pentafluorohydroxyantimonate, (η6-toluene) (η5-cyclopentadienyl) iron(1+) pentafluoroarsenate, (η6-toluene) (η5-cyclopentadienyl) iron(1+) pentafluoroantimonate, (η6-naphthalene) (η5-cyclopentadienyl)iron(1+) tetrafluoroborate, (η6-pyrene) (η5-cyclopentadienyl)iron(1+) triflate, (η6-fluorene) (η5-cyclopentadienyl) iron(1+) hexafluoroantimonate, (η6-hexamethylbenzene) (η5-cyclopentadienyl)iron(1+) pentafluorohydroxyantimonate, (η6-peryrene) (η5-cyclopentadienyl) iron(1+) hexafluoroantimonate, (η6-benzene) (η5-cyclopentadienyl)iron(1+) hexafluoroantimonate, (η6-mesitylene) (η5-cyclopentadienyl) iron(1+) hexafluoroantimonate, (η6-mesitylene) (η5-cyclopentadienyl) iron(1+) hexafluorophosphate and (η6-mesitylene) (η5-cyclopentadienyl) iron(1+) pentafluorohydroxyantimonate.

In a photopolymerization initiator represented by general formula (1) detailed, a counter anion represented by $X^-$ in the formula is preferably a counter anion containing a fluorine atom, because of stability of a complex itself, solution stability at the time of preparation of a recording layer forming composition and more efficient radical generation as a photopolymerization initiator.

As a photopolymerization initiator to photopolymerize a compound provided with an ethylenic unsaturated bond, in addition to the aforesaid compounds, utilized in combination may be commonly known conventional photopolymrization initiators such as benzoine and derivatives thereof, carbonyl compounds such as benzophenone, azo compounds such as azobisbutyronitrile, sulfer compounds such as dibenzothiazolylsulfide, peroxides such as benzoyl peroxide, halogen compounds such as 2-tribromomethane sulfonyl-pyridine, quartenary ammonium salts or substituted or unsubstituted diphenyliodonium salts, onium compounds such as a triphenylsulfonium salt, bisimidazol compounds such as 2,2-bis (o-chlorophenyl)-4,4',5,5'-tetraphenylbiimidazol and metal π-complexes such as a titanocene complex, and further, a sensitizing dye to spectrally sensitize a photopolymerization initiator is preferably employed in combination, in the case that said photopolymerization initiator has no absorption or little absorption against the wavelengths of an exposure light source utilized in holographic exposure which will be described later.

Herein, sensitizing dyes to spectrally sensitize the photopolymerization initiators utilized here include variety

of dyes well known in the art, and for example, variety of dyes such as cumalin derivatives, methine derivatives, polymethine derivatives, triarylmethane derivatives, indoline derivatives, azine derivatives, thiazine derivatives, xanthene derivatives, thioxanthene derivatives, oxazine derivatives, acrydine derivatives, cyanine derivatives, carbocyanine derivatives, merocyanine derivatives, hemicyanine derivatives, rhodacyanine derivatives, azamethine derivatives, styryl derivatives, pyrylium derivatives, thiopyrylium derivatives, porphyradine derivatives, porphyrin derivatives, phthalocyanine derivatives and pyrromethene derivatives can be utilized alone or appropriately in combination of two or more types.

As specific examples of such a photopolymerization initiator or a sensitizing dye, utilized by suitable selection can be those described, for example, in USP Nos. 5,027,436, 5,096,790, 5,147,758, 5,204,467, 5,256,520 and 6,011,180; European Patent Nos. 255,486, 256,981, 277,915, 318,893, 401,165 and 565,488; JP-A Nos. 2-236553, 5-46061, 5-216227, 5-247110, 5-257279, 6-175554, 6-175562, 6-175563, 6-175566, 6-186899, 6-195015, 6-202540, 6-202541, 6-202543, 6-202544, 6-202548, 6-324615, 6-329654, 7-13473, 7-28379, 7-84502, 7-84503, 7-181876, 9-106069, 9-309907, 2002-60429, 2002-62786 and 2002-244535.

The above-described photopolymerization initiator to photopolymerize a compound provided with an ethylenic unsaturated bond cannot be ununequivocally defined depending on the molecular weight of a photopolymerization initiator or the occupying ratio of ethylenic unsaturated bonds in a compound provided with an ethylenic unsaturated bond, however, in general, is preferably utilized in a range of 0.01 - 25 weight parts based on a compound provided with an ethylenic unsaturated bond. Further, a sensitizing dye which can spectrally sensitize a photopolymerization initiator cannot be ununequivocally defined depending on the molecular weight or mol absorbance of a dye itself, however, in general, is preferably utilized in a range of 0.01 - 25 weight parts based on a photopolymerization initiator.

In this invention, to provide a binder formed from the above-described binder forming compound with a more significant difference of the refractive index against a polymer obtained by diffusion polymerization of a compound provided with an ethylenic unsaturated bond, preferably utilized is said compound provided with an ethylenic unsaturated bond having a refractive index higher or lower than that of a binder forming compound. In particular, it is preferable to utilize a compound provided with an ethylenic unsaturated bond having a refractive index of not lower than 1.55 with respect to obtaining a polymer of a compound provided with an ethylenic unsaturated bond, and at that time a compound provided with a refractive index of around 1.50 is preferably utilized as a binder forming compound.

Such compounds provided with a (meth)acryloyl group having a refractive index of not lower than 1.55 include generally compounds provided with at least two hetero atoms such as nitrogen, oxygen, sulfur and phosphor, halogen atoms such as chlorine, bromine and iodine or aromatic rings, and specific examples of these compounds include paracumylphenoxyethylene glycol acrylate, paracumylphenoxyethylene glycol methacrylate, hydroxyethylated o-phenylphenol acrylate, hydroxyethylated β-naphthol acrylate, tribromophenyl acrylate, tribromophenyl methacrylate, triiodophenyl methacrylate, polyethyleneoxide modified tetrabromobisphenol A diacrylate, polyethyleneoxide modified tetrabromobisphenol A dimethacrylate, bis(4-methacryloylthiophenyl)sulfide, and compounds provided with a fluorene skeleton described in JP-A Nos. 6-301322, 2000-344716 and 2003-29604.

Further, for the purposes of such as to control compatibility and viscosity at the time of preparation of a holographic recording layer composition and to control dispersion polymerization at the time of holographic exposure, a compound provided with a (meth)acryloyl group having a refractive index of less than 1.55 may also be added in a range of not disturbing the purpose of providing a refractive index difference between a binder formed from a binder forming compound and a diffusion polymerization product of a compound provided with an ethylenic unsaturated bond, and such compounds provided with meth(acryloyl) group include, for example, (meth)acrylates of substituted or unsubstituted phenol, nonylphenol and 2-ethylhexanol, in addition to (meth)acrylates of alkyleneoxide adducts of alcohols thereof, as a compound provided with one (meth)acryloyl group. Listed are di(meth)acrylates of substituted or unsubstituted bisphenol A, bisphenol F, fluorene and isocyanuric acid, in addition to di(meth)acrylates of alkyleneoxide adducts of alcohols thereof, as compounds provided with two (meth)acryloyl groups. Listed are tri(meth)acrylates of pentaerythritol, trimethylolpropane and isocyanuric acid, in addition to tri(meth)acrylates of alkyleneoxide adducts of alcohols thereof, as compounds provided with three (meth)acryloyl groups, and listed are poly(meth)acrylates of pentaerythritol and dipentaerythritol as compounds provided with four or more (meth)acryloyl groups. Further, conventionally well known monomer-oligomer provided with a (meth)acryloyl group such as urethane acrylate having an urethane bond as a main chain and polyester acrylate having an ester bond as a main chain can be utilized in this invention by appropriate selection.

Herein, the aforesaid compound provided with an ethylenic unsaturated bond may be utilized alone or in combination of two or more types, the content is generally 1.0 - 50 weight% and preferably 4.0 - 40 weight%, based on a holographic recording composition, and when a polymer having a high refractive index is formed by dispersion polymerization of a compound provided with an ethylenic unsaturated bond, the aforesaid compound having a refractive index of not less than 1.55 is contained generally 50 - 100 weight% and preferably 60 - 100 weight% based on the whole compound provided with an ethylenic unsaturated bond.

As the first substrate and the second substrate utilized in a recording medium of this invention, those being transparent and generating no shrinkage and bending depending on using environmental temperatures and inactive against the aforesaid recording composition can be utilized without limitation, and such substrates include glasses such

as quartz glass, soda glass, kali glass, lead crystal glass, borosilicate glass, aluminosilicate glass, titanium crystal glass or crystallized glass; a variety of resins such as polycarbonate, polyacetal, polyallylate, polyether etherketone, polysulfone, polyether sulfone, polyimides such as polyimide-amide and polyether imide, polyamide, polyolefins such as a cyclic olefin type ring-opening polymer.

Among the aforesaid substrates, a material for the first substrate on the side of which information light and reference light are incident is more preferably glass, in view of thickness variation and gas permeability depending on environmental temperature and humidity at the time of holographic exposure. Further, the second substrate is preferably glass similar to the first substrate, however, in the case of employing a device equipped with a focus correction mechanism when information is read out by a CCD, it may not be a substrate like glass, in which expansion rate or thickness variation is depressed, but a substrate comprising resin.

Further, the transmittance of incident light of the first substrate, the side of which information light and reference light are incident, is preferably not less than 70% and more preferably not less than 80% due to small loss of light to reach a holographic recording layer. To increase transmittance in such a manner as much as possible, the surface, being opposite to the surface on which a holographic recording layer is accumulated, of the first substrate is preferably subjected to an anti-reflection treatment, and such an anti-reflection treatment is not specifically limited provided the refractive index being lower than that of the first substrate, however, preferable are inorganic metal fluorides such as $AlF_3$, $MgF_2$, $AlF_3.MgF_2$ and $CaF_2$; homopolymers, copolymers, graft polymers and block polymers containing a fluorine atom such as vinylidene fluoride and Teflon (R), in addition to organic fluoride such as modified polymers modified by a functional group containing a fluorine atom, because the refractive index becomes lower as the substrate detailed above.

Herein, a method to provide a layer comprising a fluorine type compound on a substrate cannot be ununequivocally defined depending on types of a substrate or a fluorine type compound, however, commonly known methods such as a sol-gel method, a vacuum evaporation method, a sputtering method, a DVD method or a coating method, or methods described in JP-A Nos. 7-27902, 2001-123264 and 2001-264509 by suitable selection.

The thickness of such an anti-reflection layer is not ununequivocally defined depending on a surface treatment or materials of a substrate, however, it is generally in a range of 0.001 - 20 μm and preferably in a range of 0.005 - 10 μm.

Further, with respect to such recording media utilized in holographic recording·reproducing device as described in such as JP-A No. 2002-123949 and World Patent Publication No. 99/57719, the surface on which a holographic recording layer is accumulated or the opposite surface of the second substrate is preferably provided with an anti-reflection layer, and in the case of providing such an anti-reflection layer, the reflectance of said layer against the wavelength of light to be reflected is preferably not less than 70% and more preferably not less than 80%.

The materials of such an anti-reflection layer are not specifically limited provided that a desired reflectance is obtained, however, the layer can be generally accumulated by providing a thin layer comprising such as a metal on the substrate surface. To form such an anti-reflection layer, a metal single crystal or polycrystal can be accumulated as a metal thin layer by a commonly known method such as a vacuum evaporation method, an ion plating method or a sputtering method, and as metals utilized to accumulate a metal thin layer, utilized can be alone or in combination of two or more types of metals such as aluminum, zinc, antimony, indium, selenium, tin, tantalum, chromium, lead, gold, silver, platinum, nickel, niobium, germanium, silicon, manganese, tungsten and palladium. The thickness of the metal thin layer is not limited provided that a desired reflectance can be obtained, however, is generally in a range of 1 - 3000 nm and preferably in a range of 5 - 2000 nm.

Further, in a holographic recording medium of this invention, physical patterns may be formed on one side surface of either substrate to track the position of information to be recorded or recorded information in the medium, similarly to commonly known optical disks such as a CD and a CDV, and as such patterns and methods to form the same, utilized by suitable selection can be those described, for example, in JP-A Nos. 2003-178456, 2003-228875, 2003-331464, 2004-126038, 2004-126040, 2004-126041 and 2004-127379, USP No. 6,625,100, US Patent Publication Open to Public Inspection Nos. 2004/0042375 and 2004/0067419.

On the other hand, in a holographic recording medium, it is possible to prepare a recording medium having a high memory capacity by making a holographic recording layer as thick as possible, however, it is preferable to satisfy the relationship of $0.15 \leq Dh/(D1 + D2) \leq 2.0$, when the thickness of the first substrate is D1, the thickness of the second substrate is D2 and the thickness of a holographic recording layer is Dh, in view of the using environment of said recording medium and reading error of recorded information.

Herein, a layer thickness of a holographic recording layer cannot be made thicker when $0.15 > Dh/(D1 + D2)$, or the whole recording medium may become thick because the thickness of a substrate become thick even when the thickness of a recording layer is made thicker. This case is not preferred because an excess load may be generated due to the heavy weight of the recording medium itself. While, the thickness of a recording medium can be made thin while keeping the thickness of a recording layer when $Dh/(D1 + D2) > 2.0$, however, it is not preferred because the thickness of a recording layer becomes thick compared to the thickness of a substrate resulting in deteriorated plane precision of a recording medium , layer thickness unevenness of a recording layer at using environmental temperature, and layer thickness variation of a recording layer or a possible shift of the first substrate and the second substrate with

an unexpected stress.

Further, the relationship between thickness D1 of the first substrate and thickness D2 of the second substrate is preferably D1 ≤ D2, with respect to energy losses at the time of holographic exposure, and the thickness ratio of D1 to D2 is preferably in a range of 0.20 ≤ D1/D2 ≤ 1.00 to secure the flatness of a recording medium.

Further, thickness Dh of a holographic recording layer is not unequivocally defined depending on a diffraction efficiency, a dynamic range and a special resolution of a recording layer, however is generally preferably not less than 200 μm and not more than 2.0 mm, and it is not preferable that a recording medium with a high memory capacity cannot be obtained when the thickness is less than 200 μm, while deteriorated plane precision of a recording medium and layer thickness unevenness of a recording layer at using environmental temperature may possibly result when the thickness is over 2.0 mm.

On the other hand, the shape of a recording medium is not specifically limited provided being suitable to a holographic recording-reproducing device utilized for said recording medium, however, a disk-form is preferred when it is utilized in a device described in such as USP No. 5,719,691 and JP-A No. 2002-123949, and a card form is preferred when it is utilized in a device described in such as World Patent Publication No. 99/57719.

As a method to prepare the recording medium detailed above, a holographic recording layer forming composition is prepared by mixing a holographic recording layer composition under a safelight at ordinary temperature or while being appropriately heated, and a holographic recording layer forming composition is applied on the first substrate at ordinary temperature or while being appropriately heated after the composition has been degassed to depress polymerization inhibition at the time of holographic exposure, then the second substrate is laminated thereon to make a predetermined thickness of a recording layer without introducing bubbles, finally the edge portions are sealed resulting in preparation of a recording medium. Further, the first substrate and the second substrate are fixed under a safelight in a form so as to have a predetermined space, and a holographic recording layer composition is filled between the first substrate and the second substrate by means of injection molding not to introduce bubbles or by means of reduced pressure suction not to introduce bubbles, finally the edge portions are sealed resulting in preparation of a recording medium. Herein, under a safelight means an operation in a state of wavelengths of light which activates a photopolymerizatuin initiator being cut.

Further, in the case of forming a recording medium by means of lamination, a holographic recording layer forming composition may be applied not on the first substrate but on the second substrate, or may be applied on the both of the first and second substrates. Further, to seal the edge portions of the first substrate, a holographic recording layer and the second substrate, sealing may be performed by cross-linking a liquid end-sealing material represented by a moisture curable type adhesive or by use of a ring-form end-sealing material which can keep a predetermined thickness of a holographic recording layer in advance.

Next, a method to record information on a holographic recording medium will be detailed.

The first embodiment in a holographic recording method of this invention is characterized in that, after a binder is formed on the holographic recording medium detailed above by reacting a binder forming compound before holographic exposure, holographic exposure is performed by making information light and reference light incident from the side of the first substrate based on information to be recorded, thereby activating a photopolymerization initiator, and information is recorded on a holographic recording medium by diffusion polymerization of a compound provided with an ethylenic unsaturated bond in a holographic recording layer by this active species.

Generally, since a recording layer forming composition is prepared without a solvent to apply a thick layer, it is difficult to obtain a uniform thickness or to eliminate bubbles incorporated at the time of preparation of the composition in a solid or highly viscous composition.

Therefore, fluidity is required in a state of ordinary temperature or being heated when a recording layer forming composition is prepared. In particular, it is not preferable when this recording layer forming composition is a liquid and has a low viscosity at ordinary temperature, because flatness as a recording medium is hard to be secured or there is a possibility of position shifting of a polymer, which has been formed from a compound provided with an ethylenic unsaturated bond, in a recording layer.

Therefore, in a holographic recording medium containing the aforesaid essential component, it is possible to secure the flatness and to prevent the shift of a polymer, which has been formed by diffusion polymerization of a compound provided with an ethylenic unsaturated bond, in a holographic recording layer, by cross-linking a binder forming compound before holographic exposure.

As described above, information can be recorded on a holographic recording medium by performing holographic exposure based on information after formation of a binder to be recorded resulting in activation of a photopolymerization initiator, and information is recorded on a holographic recording medium by diffusion polymerization of a compound provided with an ethylenic unsaturated bond by this active species.

Herein, in cross-linking reaction to form a binder described above in this recording method, either all the reactive combinations of functional groups or a part of them in a range of not causing a practical trouble may be cross-linked. Further, after recording information on a holographic recording medium, it is preferable to completely photoporimerize

the residual compound provided with an ethylenic unsaturated bond with a photoporimerization initiator and to completely thermally cross-link uncross-linked functional groups of a binder forming compound, which is remaining in a recording layer, each other, by light and appropriately applied heat, to fix the recorded holographic information. In this case, light utilized for exposure is preferably irradiated at once on the whole recording medium, and when heat is applied, it may be applied at any timing before, simultaneous with, or after the total exposure, as well as a plural number of heat treatments can be combined.

The second embodiment of a holographic recording method of this invention is characterized in that the holographic recording medium detailed above is subjected to a holographic exposure by making information light and reference light incident from the first substrate side based on information to be recorded, thereby a photopolymerization initiator being activated, and information is recorded on the holographic recording medium by diffusion polymerization of a compound provided with an ethylenic unsaturated bond with this active species, in addition, the recorded information is stabilized by irradiating the whole holographic recording with heat and light after finishing information recording on the holographic recording medium.

This embodiment is, different from the first embodiment described above, a recording method effective for a holographic recording medium the recording layer of which is formed by a recording layer forming composition which flows in a state of being heated but does not flow at ordinary temperature, or by a composition which is gelled or provided with thixotropy at ordinary temperature, when a recording layer forming composition is prepared.

In such recording media, it is possible to provide a level which has no problems in practical use with respect to securing flatness of said recording media and preventing shift of polymer formed by diffusion polymerization of a compound provided with an ethylenic unsaturated bond, however, it is preferable to completely photopolymerize a compound provided with an ethylenic unsaturated bond by a photopolymerization initiator and to completely thermally cross link uncross-linked functional groups each other of residual binder forming compound, after finishing information recording on a holographic recording medium, for the purpose of further improving storage stability of recorded information. In this case, similar to the first embodiment described above, light utilized for exposure is preferably irradiated at once on the whole recording medium, and when a recording medium is heated, it may be applied at any timing before, simultaneous with, or after the total exposure, as well as a plural number of heat treatments can be combined.

Further, a recording·reproducing device with respect to a holographic recording medium utilized in the first and scond embodiments of this invention is not specifically limited provided being possible to record·reproduce on a recording medium of this invention, and such recording·reproducing devices include those described, for example, in USP Nos. 5,719,691, 5,838,467, 6,163,391 and 6,414,296, US Patent Publication Open to Public Inspection No. 2002-136143, JP-A Nos. 9-305978, 10-124872, 11-219540, 2000-98862, 2000-298837, 2001-23169, 2002-83431, 2002-123949, 2002-123948 and 2003-43904, World Patent Publication No. 99/57719, 02/05270 and 02/75727.

As a laser light source utilized in the aforesaid recording · reproducing device, a laser light source, provided being able to activate a photopolymerization initiator in a recording medium resulting in holographic recording and to read out recorded hologram, can be utilized without limitation, and such light sources include a semiconductor laser of a blue violet region, an argon laser, a He-Cd laser, a YAG laser of a double frequency, a He-Ne laser, a Kr laser, a semiconductor laser of a near infrared region.

Further, in a holographic recording medium before recording and a holographic recording medium, on which a small amount of information has been recorded and is possible to be additionally recorded, are generally kept in a case or a cassette being light-tight against at least light of not more than ($\lambda$ + 100) nm and preferably of not more than ($\lambda$ + 200) nm, when the wavelength of a laser light utilized in holographic recording is $\lambda$ nm, and the recording medium is brought out from a case or cassette only when the recording medium is exposed for recording and is recorded with information by irradiating laser light under light shielded.

Further, a recording medium on which information has been recorded by a holographic recording method of this invention can be taken out of a light-tight case or cassette to be utilized as a holographic information medium which can be handled in daylight room similar to such as a CD and a DVD. This holographic information medium is characterized in that a holographic information recording layer is sandwiched between the first substrate and the second substrate, and said holographic information recording layer is provided with a region comprising a binder which is formed from at least one type of a binder forming compound selected from, a compound provided with an isocyanate group and a compound provided with a hydroxyl group, a compound provided with an isocyanate group and a compound provided with an amino group, a compound provided with a carbodiimido group and a compound provided with a carboxyl group, a compound provided with an unsaturated ester group and a compound provided with an amino group, a compound provided with an unsaturated ester group and a compound provided with a mercaptan group, a compound provided with a vinyl group and a compound provided with a silicon hydride group, a compound provided with an oxirane group and a compound provided with a mercaptan group, a compound provided with a group selected from oxirane, oxetane, tetrahydrofuran, oxepane, monocyclic actal, bicyclic acetal, lactone, cyclic orthoester and cyclic carbonato in the molecule, and a thermal cationic polymerization initiator, as a primary component; and a region comprising a radical polymer, which contains at least a compound provided with an ethylenic unsaturated bond as a monomer unit, as a primary

component formed by radical polymerization. In this case, information can be read out based on the difference of refractive indexes of a region where a binder is a primary component and a region where a radical polymer is a primary component, and information is recorded by making a refractive index of a region containing a binder as a primary component lower than that of a region comprising the aforesaid radical polymer as a primary component, which is formed by radical polymerization containing a compound provided with an ethylenic unsaturated bond and having a refractive index of not less than 1.55 as a monomer unit. Herein, in this holographic information medium, there caused little deterioration of reading out by a reproducing device due to aging because an information recorded layer hardly cause changes under ordinary handling conditions.

EXAMPLES

In the following, this invention will be explained referring to examples, however, embodiments of this invention are not limited to these examples.

Herein, shown below are binder forming compounds (A-1 - 13), compounds provided with an ethylenic unsaturated bond (B-1 - 10), photopolymerization initiators (C-1 - 5) and sensitizing dyes (D-1 - 13) utilized when a holographic recording layer is prepared.

<Binder Forming Compound>

(A-1) A compound provided with an isocyanate group) 2-isocyanateethyl-2,6-diisocyanate caproate (NCO content: 49.8 weight%, molecular weight: 253.2)
(A-2) A compound provided with an isocyanate group) Polyisocyanate compound of hexamethylene diisocyanate (NCO content: 19.7 weight%. Duranate D-101, manufactured by Asahi Kasei Co. Ltd)
(A-3) A compound provided with a hydroxyl group) A polypropyleneoxide adduct of glycerin (mean molecular weight: 1000, Uniol TG-1000, manufactured by NOF Co., Ltd.)
(A-4) A urethane curing catalyst (Neostann U-100, manufactured by Nitto Chemicals Co., Ltd.)
(A-5) Polypropyleneglycol diglycidylether (Epolight 200P, manufactured by KyoeiSha Chemical Co., Ltd.)
(A-6) A compound provided with a mercaptan group) Pentaerythiytol(tetrakismercaptopropionate)
(A-7) 2,4,6-tris(dimethylaminomethyl)phenol
(A-8) A compound provided with an oxetane group in the molecule) 3-ethyl-3-(phenoxymethyl)oxetane
(A-9) A thermal cationic polymerization initiator (Sunaid SI-45, manufactured by Sanshin Chemical Indusry Co., Ltd.)
(A-10) A compound provided with an isocyanate group) 1,8-diisocyanate-4-isocyanatemethyl-octane (NCO content: 50.2 weight%, molecular weight: 251.3)
(A-11) A compound provided with an isocyanate group) Hexamethylene diisocyanate (NCO content: 50.0 weight%)
(A-12) A compound provided with a hydroxyl group) Polypropylene glycol (average molecular weight: 1000, Uniol D-1000, manufactured by NOF Co., Ltd.)
(A-13) A compound provided with a hydroxyl group) Triethylene glycol (molecular weight: 150.2)

<Compound Provided With Ethylenic Unsaturated Bond>

(B-1) EO modified tribromophenyl acrylate (refractive index*1 = 1.564, Newfrontia BR-31, manufactured by Dai-ichi Kogyo Seiyaku Co., Ltd.)
(B-2) Hydroxyethylated β-naphthol acrylate (refractive index*1 = 1.583, NK Ester A-NP-1E, manufactured by Shin-Nakamura Chemical Industrial Co., Ltd.)
(B-3) 9,9-bis(4-(2-acryloyloxyethoxy)phenyl)fluorene (refractive index*1 = 1.615, BPEFA, manufactured by Osaka Gas Co., Ltd.)
(B-4) Phenoxyethyl acrylate (refractive index*1 = 1.519)
(B-5) 4-bromostylene (refractive index*1 = 1.594)
(B-6) Hydroxyethylated o-phenylphenol acrylate (refractive index*1 = 1.576, NK Ester A-L4, manufactured by Shin-Nakamura Chemical Industrial Co., Ltd.)
(B-7) Paracumylphenoxyethylene glycol acrylate (refractive index*1 = 1.553, NK Ester A-CMP-1E, manufactured by ShinNakamura Chemical Industrial Co., Ltd.)
(B-8) 9,9-bis(3-phenyl-4-acryloylpolyoxyethyoxy)fluorene (refractive index*1 1.597, NK Ester A-BPFL-4E, manufactured by ShinNakamura Chemical Industrial Co., Ltd.)

(B-9) Tribromophenyl acrylate (refractive index*1 = 1.567, Newfrontia BR-30, manufactured by Dai-ichi Kogyo Seiyaku Co., Ltd.)
(B-10) EO-modified tetrabromobisphenol A dimethacrylate (refractive index*1 = 1.564, Newfrontia BR-42M, manufactured by Dai-ichi Kogyo Seiyaku Co., Ltd.)

Herein, refractive index*1 was measured as a styrene 50% solution at 25 °C.

<Photopolymerization Initiator, Sensitizing Dye>

(C-1) Titanocene type photopolymerization initiator (Irgacure 784, manufactured by Ciba Special Chemical Co., Ltd.)
(C-2) (η6-cumene) (η5-cyclopentadienyl) iron(1+) hexafluorophosphate
(C-3) (η6-cumene) (η5-cyclopentadienyl)iron(1+)hexafluoroantimonate
(C-4) (η6-perylene) (η5-cyclopentadienyl)iron(1+)hexafluoroantimonate
(C-5) (η6-fluorene) (η5-cyclopentadienyl)iron(1+)hexafluoroantimonate

**D-1**

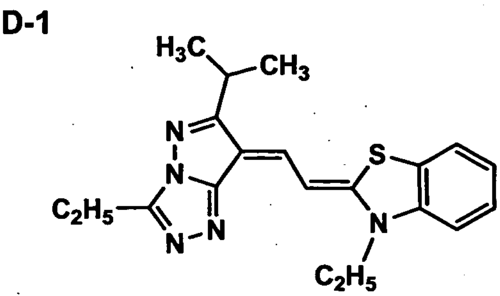

**D-2**

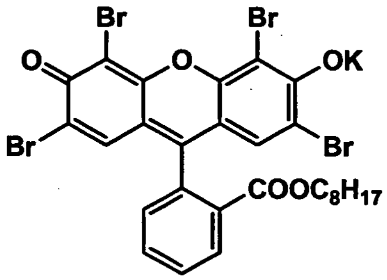

**D-3**

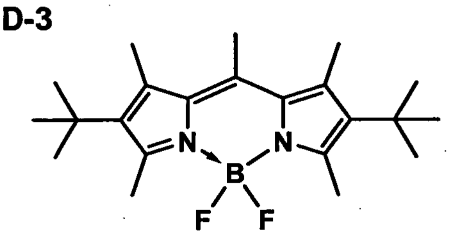

**D-4**

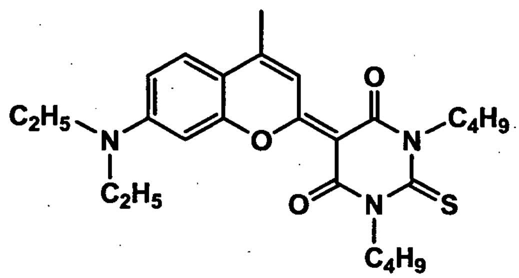

**D-5**

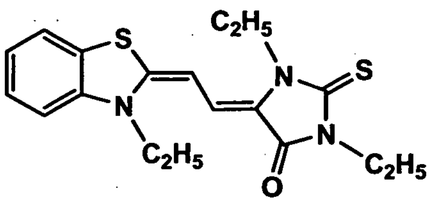

**D-6**

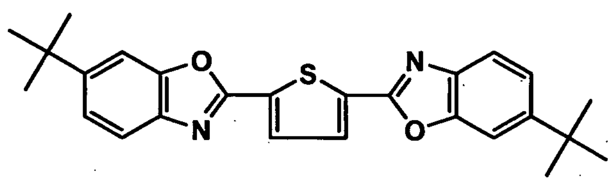

**D-7**

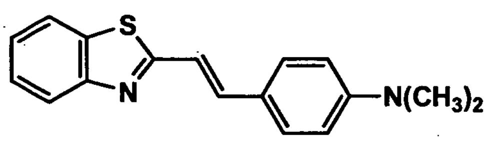

**D-8**

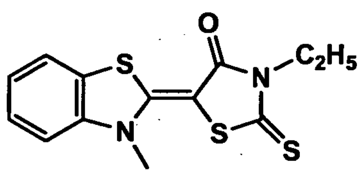

D-9

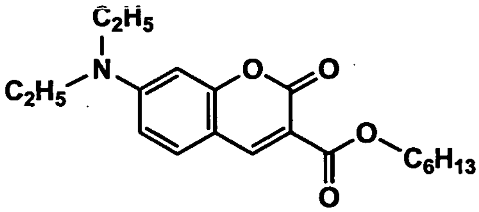

D-10

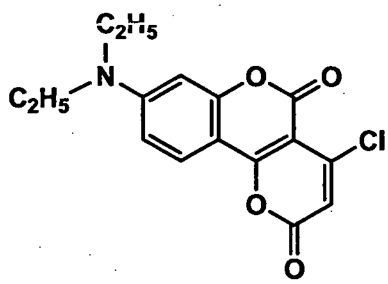

D-11

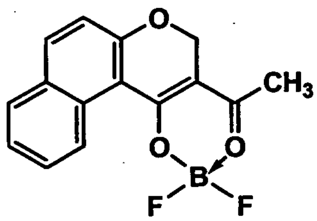

D-12

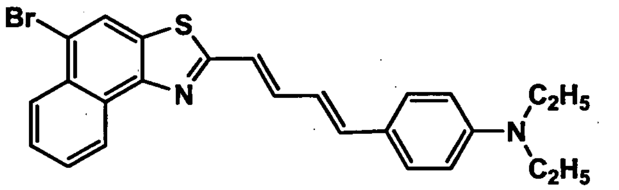

D-13

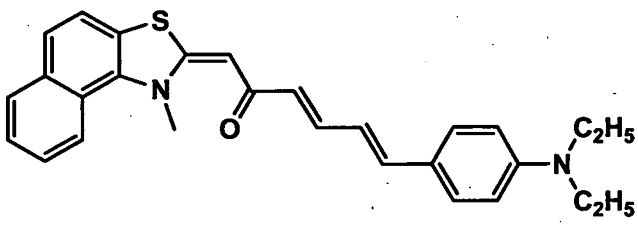

(Preparation of composition for forming holographic recording layer)

(Composition for forming holographic recording layer 1)

Under the safelight, compounds for forming binder (A-5 mentioned earlier) in weight of 48.92g and compounds for forming binder (A-7 mentioned earlier) in weight of 8.74g were mixed to prepare solution 1. Solution A containing compounds for forming binder (A-6 mentioned earlier) in weight of 30.00g and compounds having an ethylene type unsaturated bond (B-5 mentioned earlier) in weight of 11.67g prepared separately were added to the solution 1. Next, photo-polymerization initiator (C-1 mentioned earlier) in weight of 0.670g was added and dissolved, then, the composition prepared lastly was subjected to deairing with nitrogen, then, gas component contained was removed by a supersonic washer, thus, comparative composition for forming a holographic recording layer 1 was prepared.

(Compositions for forming holographic recording layer 2 - 9)

Compositions for forming holographic recording layer 2 - 9 were prepared in the same way as in the composition for forming a holographic recording layer 1 except that the compound having an ethylene type unsaturated bond and the photo-polymerization initiator were changed to the compound and the added amount described in Table 1 and sensitizing dyes in the added amount described in Table 1 were dissolved in the solution 1.

Table 1

| Holographic recording layer forming composition No. | Solution 1 | | Solution A | | Photo-polymerization initiator | | |
|---|---|---|---|---|---|---|---|
| | Sensitizing dye | | Compound having ethylene type unsaturated bond | | | | |
| | Type | Added amount (mg) | Type | Added amount (g) | Type | Added amount (g) | |
| 1 | - | | B-5 | 11.67 | C-1 | 0.670 | Comp. |
| 2 | D-4 | 11.0 | B-5 | 11.67 | C-2 | 0.581 | Inv. |
| 3 | D-4 | 11.0 | B-1/B-4 | 7.00/3.00 | C-2 | 0.581 | Inv. |
| 4 | D-4 | 11.0 | B-1/B-4 | 7.00/3.00 | C-3 | 0.717 | Inv. |
| 5 | D-4 | 5.5 | B-1/B-4 | 7.00/3.00 | C-4 | 0.916 | Inv. |
| 6 | D-5 | 6.7 | B-2/B-4 | 7.00/3.00 | C-5 | 0.787 | Inv. |
| 7 | D-1 | 4.3 | B-3/B-4 | 8.00/2.00 | C-4 | 0.916 | Inv. |
| 8 | D-2 | 11.0 | B-3/B-4 | 8.00/2.00 | C-4 | 0.916 | Inv. |
| 9 | D-3 | 4.4 | B-3/B-4 | 8.00/2.00 | C-4 | 0.916 | Inv. |
| Comp.: Comparative example Inv.: The invention | | | | | | | |

(Composition for forming holographic recording layer 10)

Under the safelight, 2,6-di (t-butyl)-4-methylphenol in weight of 36.0mg and urethane hardening catalyzer (A-4 mentioned earlier) in weight of 67.1mg were mixed and dissolved in compound for forming a binder (A-3 mentioned earlier) to prepare solution 2. Separately, compound for forming a binder (A-1 mentioned earlier) in weight of 7.92g, compound for forming a binder (A-2 mentioned earlier) in weight of 23.75g, compound having an ethylene type unsaturated bond (B-1 mentioned earlier) in weight of 8.00g, and compound having an ethylene type unsaturated bond (B-4 mentioned earlier) in weight of 2.00g were mixed and dissolved to prepare solution B, then the solution B was added to the solution 2 described earlier after the photo-polymerization initiator (C-1 mentioned earlier) in weight of 0.500g was added and dissolved in the solution B, then, the composition prepared lastly was subjected to deairing with nitrogen, then, gas component contained was removed by a supersonic washer, thus, comparative composition for forming a holographic recording layer 10 was prepared.

(Compositions for forming holographic recording layer 11 - 24)

Compositions for forming holographic recording layer 11 - 24 were prepared in the same way as in the composition for forming a holographic recording layer 10 except that the compound having an ethylene type unsaturated bond and the photo-polymerization initiator were changed to the compound and the added amount described in Table 2 and sensitizing dyes in the added amount described in Table 2 were dissolved in the solution 2.

Table 2

| Holographic recording layer forming composi-tion No. | Solution 1 | | Solution A | | Photo-polymeriza-tion initiator | | |
|---|---|---|---|---|---|---|---|
| | Sensitizing dye | | Compound having ethylene type unsaturated bond | | | | |
| | Type | Added amount (mg) | Type | Added amount (g) | Type | Added amount (g) | |
| 10 | - | | B-1/B-4 | 8.00/2.00 | C-1 | 0.500 | Comp. |
| 11 | D-2 | 13.8 | B-1/B-4 | 8.00/2.00 | C-2 | 0.433 | Inv. |
| 12 | D-2 | 13.8 | B-1/B-4 | 8.00/2.00 | C-3 | 0.535 | Inv. |
| 13 | D-2 | 6.9 | B-1/B-4 | 8.00/2.00 | C-4 | 0.684 | Inv. |

Table continued

| Holographic recording layer forming composi-tion No. | Solution 1 | | Solution A | | Photo-polymeriza-tion initiator | | |
|---|---|---|---|---|---|---|---|
| | Sensitizing dye | | Compound having ethylene type unsaturated bond | | | | |
| | Type | Added amount (mg) | Type | Added amount (g) | Type | Added amount (g) | |
| 14 | D-2 | 11.0 | B-1/B-4 | 8.00/2.00 | C-5 | 0.587 | Inv. |
| 15 | D-2 | 11.0 | B-2/B-4 | 8.00/2.00 | C-2 | 0.433 | Inv. |
| 16 | D-2 | 11.0 | B-3/B-4 | 9.00/1.00 | C-2 | 0.433 | Inv. |
| 17 | D-4 | 11.0 | B-3/B-4 | 9.00/1.00 | C-2 | 0.433 | Inv. |
| 18 | D-5 | 8.4 | B-3/B-4 | 9.00/1.00 | C-2 | 0.433 | Inv. |
| 19 | D-6 | 10.1 | B-3/B-4 | 8.00/2.00 | C-2 | 0.433 | Inv. |
| 20 | D-7 | 3.3 | B-3/B-4 | 8.00/2.00 | C-2 | 0.433 | Inv. |
| 21 | D-8 | 1.7 | B-3/B-4 | 8.00/2.00 | C-2 | 0.433 | Inv. |
| 22 | D-9 | 8.1 | B-3/B-4 | 8.00/2.00 | C-2 | 0.433 | Inv. |
| 23 | D-10 | 7.5 | B-3/B-4 | 8.00/2.00 | C-2 | 0.433 | Inv. |
| 24 | D-11 | 6.7 | B-3/B-4 | 8.00/2.00 | C-2 | 0.433 | Inv. |
| Comp.: Comparative example Inv.: The invention | | | | | | | |

(Composition for forming holographic recording layer 25)

Under the safelight, compound for forming a binder (A-8 mentioned earlier) in weight of 89.32g, compound having an ethylene type unsaturated bond (B-1 mentioned earlier) in weight of 9.00g, compound having an ethylene type unsaturated bond (B-4 mentioned earlier) in weight of 1.00g, photo-polymerization initiator (C-2 mentioned earlier) in weight of 0.923g and sensitizing dyes (D-3 mentioned earlier) in weight of 9.6mg were mixed and dissolved to prepare solution C. To this solution C, there was added and dissolved thermal cation polymerization initiator (A-9 mentioned earlier) in weight of 0.179g, then, the composition prepared lastly was subjected to deairing with nitrogen, then, gas component contained was removed by a supersonic washer, thus, composition for forming a holographic recording layer 25 was prepared.

(Compositions for forming holographic recording layer 26 - 30)

Compositions for forming holographic recording layer 26 - 30 were prepared in the same way as in the composition for forming a holographic recording layer 25 except that the compound having an ethylene type unsaturated bond, the photo-polymerization initiator and sensitizing dyes were changed to the compounds and the added amount described in Table 3.

Table 3

| Holographic recording layer forming composi-tion No. | Solution 1 | | Solution A | | Photo-polymerization initiator | | |
|---|---|---|---|---|---|---|---|
| | Sensitizing Sensitizing dye | | Compound having ethylene type unsaturated bond | | | | |
| | Type | Added amount (mg) | Type | Added amount (g) | Type | Added amount (g) | |
| 25 | D-4 | 11.0 | B-1/B-4 | 9.00/1.00 | C-2 | 0.433 | Inv. |
| 26 | D-4 | 11.0 | B-1/B-4 | 8.00/2.00 | C-3 | 0.535 | Inv. |
| 27 | D-4 | 5.5 | B-1/B-4 | 8.00/2.00 | C-4 | 0.684 | Inv. |

Table continued

| Holographic recording layer forming composition No. | Solution 1 | | Solution A | | Photo-polymerization initiator | | |
|---|---|---|---|---|---|---|---|
| | Sensitizing Sensitizing dye | | Compound having ethylene type unsaturated bond | | | | |
| | Type | Added amount (mg) | Type | Added amount (g) | Type | Added amount (g) | |
| 28 | D-4 | 8.8 | B-1/B-4 | 8.00/2.00 | C-5 | 0.587 | Inv. |
| 29 | D-3 | 8.8 | B-3/B-4 | 9.00/1.00 | C-2 | 0.433 | Inv. |
| 30 | D-5 | 8.4 | B-3/B-4 | 9.00/1.00 | C-2 | 0.433 | Inv. |
| Comp.: Comparative example Inv.: The invention | | | | | | | |

(Compositions for forming holographic recording layer 31 - 47)

Under the safelight, a compound having an ethylene type unsaturated bond was dissolved in an isocyanate compound shown in Table 4 to obtain a solution, and then, a photo-polymerization initiator was dissolved in the solution. Separately, a solution wherein sensitizing dyes and urethane hardening catalyzer (Neostann U-100 made by Nittokasei Co.) were dissolved in a compound having two or more hydroxyl groups was added to a solution in which the photo-polymerization initiator was dissolved, and the composition prepared lastly was subjected to deairing with nitrogen, then, gas component contained was removed by a vacuum deairing, thus, compositions for holographic recording 31 - 46 were prepared.

Table 4

| Holographic recording layer forming composition | Binder forming compound | | | | | Compound having ethylene type unsaturated bond | | Photo-polymerization tion initiator | | Sensitizing dye | | |
|---|---|---|---|---|---|---|---|---|---|---|---|---|
| | Compound containing isocyanate group | | Compound having two or more hydroxyl groups in molecule | | Urethane hardening catalyzer | | | | | | | |
| | Type | Added amount (g) | Type | Added amount (g) | Added amount (mg) | Type | Added amount (g) | Type | Added amount (g) | Type | Added amount (mg) | |
| 31 | A-11/A-2 | 1.000/5.076 | A-3 | 17.68 | - | B-6 | 1.926 | C-1 | 0.106 | D-1 | 2.4 | Comp. |
| 32 | A-1/A-2 | 1.000/5.058 | A-3/A-13 | 14.09/0.529 | - | B-6 | 1.798 | C-2 | 0.078 | D-4 | 3.2 | Inv. |
| 33 | A-1/A-2 | 1.000/5.058 | A-3/A-13 | 14.09/0.529 | - | B-7 | 1.798 | C-2 | 0.078 | D-4 | 3.2 | Inv. |
| 34 | A-1/A-2 | 1.000/5.058 | A-3/A-13 | 14.09/0.529 | - | B-8 | 1.798 | C-2 | 0.078 | D-4 | 3.2 | Inv. |
| 35 | A-1/A-2 | 1.000/5.058 | A-3/A-13 | 14.09/0.529 | - | B-9/B-4 | 1.619/0.180 | C-2 | 0.078 | D-4 | 3.2 | Inv. |
| 36 | A-1/A-2 | 1.000/5.058 | A-3/A-13 | 14.09/0.529 | - | B-1/B-4 | 1.619/0.180 | C-2 | 0.078 | D-4 | 3.2 | Inv. |
| 37 | A-1/A-2 | 1.000/5.058 | A-3/A-13 | 14.09/0.529 | - | B-10/B-4 | 1.619/0.180 | C-2 | 0.078 | D-4 | 3.2 | Inv. |
| 38 | A-1/A-2 | 1.000/5.058 | A-3/A-1.3 | 14.09/0.529 | - | B-1/B-4 | 1.619/0.180 | C-2 | 0.078 | D-2 | 4.5 | Inv. |
| 39 | A-1/A-2 | 1.000/5.058 | A-3/A-1:3 | 14.09/0.529 | - | B-1/B-4 | 1.619/0.180 | C-2 | 0.078 | D-3 | 2.4 | Inv. |
| 40 | A-10/A-2 | 1.000/7.642 | A-12 | 23.66 | 27.5 | B-1/B-4 | 1.843/0.205 | C-2 | 0.150 | D-2 | 3.3 | Inv. |
| 41 | A-1/A-2 | 1.000/7.587 | A-12 | 23.49 | 27.5 | B-1/B-4 | 1.843/0.205 | C-2 | 0.150 | D-2 | 3.3 | Inv. |
| 42 | A-1/A-2 | 1.000/7.587 | A-12 | 23.49 | 27.5 | B-1/B-4 | 1.843/0.205 | C-2 | 0.150 | D-3 | 3.5 | Inv. |
| 43 | A-1/A-2 | 1.000/7.587 | A-12 | 23.49 | 27.5 | B-1/B-4 | 1.843/0.205 | C-2 | 0.150 | D-4 | 3.6 | Inv. |
| 44 | A-1/A-2 | 1.000/7.587 | A-12 | 23.49 | 27.5 | B-1/B-4 | 1.843/0.205 | C-2 | 0.150 | D-5 | 3.4 | Inv. |
| 45 | A-1/A-2 | 1.000/7.587 | A-12 | 23.49 | 27.5 | B-1/B-4 | 1.843/0.205 | C-2 | 0.150 | D-12 | 3.6 | Inv. |
| 46 | A-1/A-2 | 1.000/7.587 | A-12 | 23.49 | 27.5 | B-1/B-4 | 1.843/0.205 | C-2 | 0.150 | D-13 | 3.3 | Inv. |
| Comp.: Comparative example Inv.: The invention | | | | | | | | | | | | |

(Preparation of holographic recording media)

(Manufacturing method 1)

As the first and second base materials, one side of 0.5 mm (d1, d2)-thick glass was subjected to anti-reflection processing so that the reflectance for incident light perpendicular to the wavelength of 532 nm may come to 0.1%. Then, on the surface of the first base material which has not been subjected to anti-reflection processing, there were provided compositions for holographic recording described in Tables 1 - 3, with a polyethylene terephthalate sheet that serves as a spacer so that a thickness (Dh) of a recording layer described in Table 4 may be obtained, and then, the surface of the second base material which has not been subjected to anti-reflection processing was pasted on the composition for holographic recording while preventing that an air layer is caught, thus, the first base material and the second base material were pasted together through the spacer. Lastly, an end portion was sealed with adhesives of a moisture-hardening type, and heat treatment was given under the heat treatment condition described in Table 5, to prepare holographic recording media.

Table 5

| Holographic recording medium No. | Holographic recording layer forming composition No. | Heat treatment conditions | | Recording layer thickness (mm) | Dh/(d1+d2) | |
|---|---|---|---|---|---|---|
| | | Temperature (°C) | Time (hr) | | | |
| 1 | 1 | 20 | 60 | 0.50 | 0.50 | Comp. |
| 2 | 2 | 20 | 60 | 0.50 | 0.50 | Inv. |
| 3 | 3 | 20 | 60 | 0.50 | 0.50 | Inv. |
| 4 | 4 | 20 | 60 | 0.50 | 0.50 | Inv. |
| 5 | 5 | 20 | 60 | 0.50 | 0.50 | Inv. |
| 6 | 6 | 20 | 60 | 0.50 | 0.50 | Inv. |
| 7 | 7 | 25 | 60 | 0.50 | 0.50 | Inv. |
| 8 | 8 | 25 | 60 | 0.50 | 0.50 | Inv. |
| 9 | 9 | 25 | 60 | 0.50 | 0.50 | Inv. |
| 10 | 10 | 25 | 48 | 0.50 | 0.50 | Comp. |
| 11 | 19 | 25 | 48 | 0.50 | 0.50 | Inv. |
| 12 | 20 | 25 | 48 | 0.50 | 0.50 | Inv. |
| 13 | 21 | 25 | 48 | 0.50 | 0.50 | Inv. |
| 14 | 22 | 25 | 48 | 0.50 | 0.50 | Inv. |
| 15 | 23 | 25 | 48 | 0.50 | 0.50 | Inv. |
| 16 | 24 | 25 | 48 | 0.50 | 0.50 | Inv. |
| 17 | 25 | 25 | 72 | 0.50 | 0.50 | Inv. |
| 18 | 26 | 25 | 72 | 0.50 | 0.50 | Inv. |
| 19 | 27 | 25 | 72 | 0.50 | 0.50 | Inv. |
| 20 | 28 | 25 | 72 | 0.50 | 0.50 | Inv. |
| 21 | 29 | 25 | 72 | 0.50 | 0.50 | Inv. |
| 22 | 30 | 25 | 72 | 0.50 | 0.50 | Inv. |
| 23 | 1 | 40 | 48 | 0.50 | 0.50 | Comp. |
| 24 | 13 | 30 | 72 | 0.50 | 0.50 | Inv. |
| 25 | 14 | 30 | 72 | 0.50 | 0.50 | Inv. |

Table continued

| Holographic recording medium No. | Holographic recording layer forming composition No. | Heat treatment conditions | | Recording layer thickness (mm) | Dh/(d1+d2) | |
|---|---|---|---|---|---|---|
| | | Temperature (°C) | Time (hr) | | | |
| 26 | 15 | 30 | 72 | 0.50 | 0.50 | Inv. |
| 27 | 16 | 30 | 72 | 0.50 | 0.50 | Inv. |
| 28 | 17 | 30 | 72 | 0.50 | 0.50 | Inv. |
| 29 | 18 | 30 | 72 | 0.50 | 0.50 | Inv. |
| 30 | 24 | 30 | 72 | 0.50 | 0.50 | Inv. |
| 31 | 25 | 30 | 72 | 0.50 | 0.50 | Inv. |
| 32 | 28 | 20 | 72 | 0.50 | 0.50 | Inv. |
| 33 | 29 | 20 | 72 | 0.50 | 0.50 | Inv. |
| 34 | 30 | 20 | 72 | 0.50 | 0.50 | Inv. |
| 35 | 31 | 20 | 72 | 0.50 | 0.50 | Inv. |
| 36 | 32 | 20 | 72 | 0.50 | 0.50 | Inv. |
| 37 | 33 | 20 | 72 | 0.50 | 0.50 | Inv. |
| 38 | 34 | 20 | 72 | 0.50 | 0.50 | Inv. |
| 39 | 35 | 20 | 72 | 0.50 | 0.50 | Inv. |
| Comp.: Comparative example Inv.: The invention | | | | | | |

(Manufacturing method 2)

The first base material was prepared by performing anti-reflection processing on one side of 0.5 mm (d1)-thick glass so that the reflectance for incident light perpendicular to the wavelength of 532 nm may come to 0.1%, and the second base material was prepared by performing aluminum vacuum evaporation on one side of 0.5 mm (d2)-thick glass so that the reflectance for incident light perpendicular to the wavelength of 532 nm may come to 90%. Then, on the surface of the first base material which has not been subjected to anti-reflection processing, there were provided compositions for holographic recording described in Tables 1 - 3, with a polyethylene terephthalate sheet that serves as a spacer so that a thickness (Dh) of a recording layer described in Table 5 may be obtained, and then, the surface of the second base material which has been subjected to aluminum vacuum evaporation was pasted on the composition for holographic recording while preventing that an air layer is caught, thus, the first base material and the second base material were pasted together through the spacer. Lastly, an end portion was sealed with adhesives of a moisture-hardening type, and heat treatment was given under the heat treatment condition described in Table 6, to prepare holographic recording media.

Table 6

| Holographic recording medium No. No. | Holographic recording layer forming composition No. | Heat treatment conditions | | Recording layer thickness thickness (mm) | Dh/(d1+d2) | |
|---|---|---|---|---|---|---|
| | | Temperature (°C) | Time (hr) | | | |
| 40 | 10 | 25 | 60 | 0.50 | 0.50 | Comp. |
| 41 | 11 | 25 | 60 | 0.50 | 0.50 | Inv. |
| 42 | 12 | 25 | 60 | 0.50 | 0.50 | Inv. |
| 43 | 13 | 25 | 60 | 0.50 | 0.50 | Inv. |
| 44 | 14 | 25 | 60 | 0.50 | 0.50 | Inv. |
| 45 | 15 | 25 | 60 | 0.50 | 0.50 | Inv. |

Table continued

| Holographic recording medium No. No. | Holographic recording layer forming composition No. | Heat treatment conditions | | Recording layer thickness thickness (mm) | Dh/(d1+d2) | |
|---|---|---|---|---|---|---|
| | | Temperature (°C) | Time (hr) | | | |
| 46 | 16 | 25 | 60 | 0.50 | 0.50 | Inv. |
| 47 | 17 | 25 | 60 | 0.50 | 0.50 | Inv. |
| 48 | 18 | 25 | 60 | 0.50 | 0.50 | Inv. |
| 49 | 19 | 20 | 60 | 0.50 | 0.50 | Inv. |
| 50 | 20 | 20 | 60 | 0.50 | 0.50 | Inv. |
| 51 | 21 | 20 | 60 | 0.50 | 0.50 | Inv. |
| 52 | 22 | 20 | 60 | 0.50 | 0.50 | Inv. |
| 53 | 23 | 20 | 60 | 0.50 | 0.50 | Inv. |
| 54 | 24 | 20 | 60 | 0.50 | 0.50 | Inv. |
| 55 | 1 | 50 | 24 | 0.50 | 0.50 | Comp. |
| 56 | 24 | 40 | 48 | 0.50 | 0.50 | Inv. |
| 57 | 25 | 40 | 48 | 0.50 | 0.50 | Inv. |
| 58 | 28 | 20 | 72 | 0.50 | 0.50 | Inv. |
| 59 | 29 | 20 | 72 | 0.50 | 0.50 | Inv. |
| 60 | 30 | 20 | 72 | 0.50 | 0.50 | Inv. |
| 61 | 31 | 20 | 72 | 0.50 | 0.50 | Inv. |
| 62 | 32 | 20 | 72 | 0.50 | 0.50 | Inv. |
| 63 | 33 | 20 | 72 | 0.50 | 0.50 | Inv. |
| 64 | 34 | 20 | 72 | 0.50 | 0.50 | Inv. |
| Comp.: Comparative example Inv.: The invention | | | | | | |

(Recording on holographic recording medium and evaluation)

(Recording on holographic recording medium and evaluation 1)

On the holographic recording media which were prepared in the aforesaid way and left for one week at 50°C under the condition of light shielding and on the holographic recording media which were prepared in the aforesaid way, a series of multiple holograms were written respectively in accordance with procedures described in U. S. Patent No. 5,719,691, and sensitivity (recording energy) was measured and evaluated in accordance with the following method, and the results thereof thus obtained are shown in Table 7.

(Measurement of sensitivity)

A digital pattern was displayed, by a holographic manufacturing apparatus equipped with Nd: YAG laser (532 nm), on a holographic recording medium which has not been left for one week at 50°C under the safelight, and a hologram was obtained by giving holographic exposure of the digital pattern with energy of 0.1 - 30 $mJ/cm^2$. Then, regenerated light was read by CCD by using Nd: YAG laser (532 nm) as reference light, and minimum exposure amount by which an excellent digital pattern was regenerated was measured as sensitivity (S11). Further, the holographic recording medium left for one week at 50°C was evaluated in the same way as in the foregoing and minimum exposure amount by which an excellent digital pattern was regenerated was measured as sensitivity (S12).

Table 7

| Holographic recording medium No. | S11 [mJ/cm$^2$] | S12 [mJ/cm$^2$] | |
|---|---|---|---|
| 1 | 17 | 21 | Comp. |
| 2 | 10 | 12 | Inv. |
| 3 | 7.1 | 7.5 | Inv. |
| 4 | 6.9 | 7.2 | Inv. |
| 5 | 6.9 | 7.1 | Inv. |
| 6 | 6.2 | 6.4 | Inv. |
| 17 | 2.3 | 2.5 | Inv. |
| 18 | 2.5 | 2.8 | Inv. |
| 19 | 2.3 | 2.5 | Inv. |
| 20 | 2.3 | 2.5 | Inv. |
| 21 | 2.1 | 2.4 | Inv. |
| 22 | 2.2 | 2.4 | Inv. |
| Comp.: Comparative example<br>Inv.: The invention | | | |

The above table shows that the sensitivity of the recording medium of the invention before and after preservation is higher than that in comparative examples.

(Recording on holographic recording medium and evaluation 2)

On the holographic recording media which were prepared in the aforesaid way and left for one week at 50°C under the condition of light shielding and on the holographic recording media which were prepared in the aforesaid way, a series of multiple holograms were written respectively in accordance with procedures described in U. S. Patent No. 5,719,691, and sensitivity (recording energy) was measured and evaluated in accordance with the following method, and the results thereof thus obtained are shown in Table 8.

(Measurement of sensitivity)

A digital pattern was displayed, by a holographic manufacturing apparatus equipped with Nd: YAG laser (532 nm), on a holographic recording medium which has not been left for one week at 50°C under the safelight, and a hologram was obtained by giving holographic exposure of the digital pattern with energy of 0.1 - 30 mJ/cm$^2$. Then, a holographic recording medium was heated and processed for 5 minutes at 100°C after being processed for 5 minutes under a sunshine fade meter of 70000 lux. With respect to this processed recording medium, regenerated light was read by CCD by using Nd: YAG laser (532 nm) as reference light under the safelight, and minimum exposure amount by which an excellent digital pattern was regenerated was measured as sensitivity (S21). Further, the holographic recording medium left for one week at 50°C was evaluated in the same way as in the foregoing and minimum exposure amount by which an excellent digital pattern was regenerated was measured as sensitivity (S22).

Table 8

| Holographic recording medium No. | S21 [mJ/cm$^2$] | S22 [mJ/cm$^2$] | |
|---|---|---|---|
| 1 | 18 | 23 | Comp. |
| 3 | 7.5 | 7.6 | Inv. |
| 4 | 7.2 | 7.7 | Inv. |
| 5 | 7.1 | 7.3 | Inv. |
| 6 | 6.3 | 6.5 | Inv. |
| 7 | 6.3 | 6.6 | Inv. |

Table continued

| Holographic recording medium No. | S21 [mJ/cm$^2$] | S22 [mJ/cm$^2$] | |
|---|---|---|---|
| 8 | 6.2 | 6.5 | Inv. |
| 9 | 6.1 | 6.4 | Inv. |
| Comp.: Comparative example<br>Inv.: The invention | | | |

The above table shows that the sensitivity of the recording medium of the invention before and after preservation is higher than that in comparative examples.

(Recording on holographic recording medium and evaluation 3)

On the holographic recording media which were prepared in the aforesaid way and left for one week at 50°C under the condition of light shielding and on the holographic recording media which were prepared in the aforesaid way, a series of multiple holograms were written respectively in accordance with procedures described in TOKKAI No. 2002-123949, and sensitivity (recording energy) was measured and evaluated in accordance with the following method, and the results thereof thus obtained are shown in Table 9.

(Measurement of sensitivity)

A digital pattern was displayed, by a holographic manufacturing apparatus equipped with Nd: YAG laser (532 nm), on a holographic recording medium which has not been left for one week at 50°C under the safelight, and a hologram was obtained by giving holographic exposure of the digital pattern with energy of 0.1 - 30 mJ/cm$^2$. Then, a holographic recording medium was heated and processed for 5 minutes at 100°C after being processed for 5 minutes under a sunshine fade meter of 70000 lux. With respect to this processed recording medium, regenerated light was read by CCD by using Nd: YAG laser (532 nm) as reference light under the safelight, and minimum exposure amount by which an excellent digital pattern was regenerated was measured as sensitivity (S31). Further, the holographic recording medium left for one week at 50°C was evaluated in the same way as in the foregoing and minimum exposure amount by which an excellent digital pattern was regenerated was measured as sensitivity (S32) .

Table 9

| Holographic recording medium No. | S31 [mJ/cm$^2$] | S32 [mJ/cm$^2$] | |
|---|---|---|---|
| 40 | 2.2 | 2.8 | Comp. |
| 41 | 1.5 | 1.7 | Inv. |
| 42 | 1.6 | 1.8 | Inv. |
| 43 | 1.6 | 1.9 | Inv. |
| 44 | 1.6 | 1.9 | Inv. |
| 45 | 1.5 | 1.7 | Inv. |
| 46 | 1.5 | 1.7 | Inv. |
| 47 | 1.7 | 1.9 | Inv. |
| 48 | 1.6 | 1.8 | Inv. |
| Comp.: Comparative example<br>Inv.: The invention | | | |

The above table shows that the sensitivity of the recording medium of the invention before and after preservation is higher than that in comparative examples.

(Recording on holographic recording medium and evaluation 4)

On the holographic recording media which were prepared in the aforesaid way and left for one week at 50°C

under the condition of light shielding and on the holographic recording media which were prepared in the aforesaid way, a series of multiple holograms were written respectively in accordance with procedures described in U. S. Patent No. 5,719,691, and sensitivity (recording energy) was measured and evaluated in accordance with the following method, and the results thereof thus obtained are shown in Table 10.

(Measurement of sensitivity)

A digital pattern was displayed, by a holographic manufacturing apparatus equipped with a violet zone semiconductor laser (405 nm), on a holographic recording medium which has not been left for one week at 50°C under the safelight, and a hologram was obtained by giving holographic exposure of the digital pattern with energy of 0.1 - 30 $mJ/cm^2$. Then, a holographic recording medium was heated and processed for 5 minutes at 100°C after being processed for 5 minutes under a sunshine fade meter of 70000 lux. With respect to this processed recording medium, regenerated light was read by CCD by using the violet zone semiconductor laser (405 nm) as reference light under the safelight, and minimum exposure amount by which an excellent digital pattern was regenerated was measured as sensitivity (S41). Further, the holographic recording medium left for one week at 50°C was evaluated in the same way as in the foregoing and minimum exposure amount by which an excellent digital pattern was regenerated was measured as sensitivity (S42).

Table 10

| Holographic recording medium No. | S41 [$mJ/cm^2$] | S42 [$mJ/cm^2$] | |
|---|---|---|---|
| 10 | 18 | 23 | Comp. |
| 11 | 2.3 | 2.8 | Inv. |
| 12 | 2.2 | 3.1 | Inv. |
| 13 | 2.2 | 2.7 | Inv. |
| 14 | 2.0 | 2.5 | Inv. |
| 15 | 2.1 | 2.6 | Inv. |
| 16 | 2.2 | 2.8 | Inv. |
| comp.: comparative example<br>Inv.: The invention | | | |

The above table shows that the sensitivity of the recording medium of the invention before and after preservation is higher than that in comparative examples.

(Recording on holographic recording medium and evaluation 5)

On the holographic recording media which were prepared in the aforesaid way and left for one week at 50°C under the condition of light shielding and on the holographic recording media which were prepared in the aforesaid way, a series of multiple holograms were written respectively in accordance with procedures described in TOKKAI No. 2002-123949, and sensitivity (recording energy) was measured and evaluated in accordance with the following method, and the results thereof thus obtained are shown in Table 11.

(Measurement of sensitivity)

A digital pattern was displayed, by a holographic manufacturing apparatus equipped with a violet zone semiconductor laser (405 nm), on a holographic recording medium which has not been left for one week at 50°C under the safelight, and a hologram was obtained by giving holographic exposure of the digital pattern with energy of 0.1 - 30 $mJ/cm^2$. Then, a holographic recording medium was heated and processed for 5 minutes at 100°C after being processed for 5 minutes under a sunshine fade meter of 70000 lux. With respect to this processed recording medium, regenerated light was read by CCD by using the violet zone semiconductor laser (405 nm) as reference light under the safelight, and minimum exposure amount by which an excellent digital pattern was regenerated was measured as sensitivity (S51). Further, the holographic recording medium left for one week at 50°C was evaluated in the same way as in the foregoing and minimum exposure amount by which an excellent digital pattern was regenerated was measured as sensitivity (S52).

Table 11

| Holographic recording medium No. | S51 [mJ/cm$^2$] | S52 [mJ/cm$^2$] | |
|---|---|---|---|
| 40 | 2.5 | 3.3 | Comp. |
| 49 | 1.8 | 2.1 | Inv. |
| 50 | 1.7 | 2.0 | Inv. |
| 51 | 1.6 | 1.9 | Inv. |
| 52 | 1.5 | 1.8 | Inv. |
| 53 | 1.6 | 1.8 | Inv. |
| 54 | 1.7 | 1.9 | Inv. |
| Comp.: Comparative example<br>Inv.: The invention | | | |

The above table shows that the sensitivity of the recording medium of the invention before and after preservation is higher than that in comparative examples.

(Evaluation of holographic information medium)

A holographic information medium manufactured based on Tables 8, 9, 10 and 11 wherein recorded information is fixed was preserved under the following conditions, then, a digital pattern was regenerated in a way suited for each information medium to be evaluated, before and after the preservation, and a difference between the minimum exposure amount with which an excellent digital pattern was regenerated before the preservation and that after the preservation was evaluated in the following method, and the results obtained are shown in Table 12.

(Storage stability for heat)

A holographic information medium was preserved for two weeks at 80°C, and a difference (ΔSh) between the minimum exposure sensitivity before the preservation and that after the preservation was obtained.
Minimum exposure sensitivity difference (ΔSh) = Minimum exposure sensitivity after preservation (S2h) - Minimum exposure sensitivity before preservation (S1h)

(Storage stability for light)

After the preservation for one week at 35°C under a sunshine fade meter of 70000 lux, difference (ΔSw) between the minimum exposure sensitivity before the preservation and that after the preservation was obtained.
Minimum exposure sensitivity difference (ΔSw) = Minimum exposure sensitivity after preservation (S2w) - Minimum exposure sensitivity before preservation (S1w)

Table 12

| Holographic information medium No. | Holographic recording medium | ΔSh [mJ/cm$^2$] | ΔSw [mJ/cm$^2$] No. |
|---|---|---|---|
| 1 | 4 | 0.1 | 0.2 |
| 2 | 5 | 0.1 | 0.2 |
| 3 | 6 | 0.1 | 0.2 |
| 4 | 7 | 0.1 | 0.2 |
| 5 | 8 | 0.1 | 0.2 |
| 6 | 9 | 0.1 | 0.2 |
| 7 | 41 | 0.1 | 0.2 |
| 8 | 42 | 0.1 | 0.2 |
| 9 | 43 | 0.1 | 0.2 |

Table continued

| Holographic information medium No. | Holographic recording medium | ΔSh [mJ/cm$^2$] | ΔSw [mJ/cm$^2$] No. |
|---|---|---|---|
| 10 | 44 | 0.1 | 0.2 |
| 11 | 45 | 0.1 | 0.2 |
| 12 | 46 | 0.1 | 0.2 |
| 13 | 47 | 0.1 | 0.2 |
| 14 | 48 | 0.1 | 0.2 |
| 15 | 12 | 0.1 | 0.2 |
| 16 | 13 | 0.1 | 0.2 |
| 17 | 14 | 0.1 | 0.2 |
| 18 | 15 | 0.1 | 0.2 |
| 19 | 50 | 0.1 | 0.2 |
| 20 | 51 | 0.1 | 0.2 |
| 21 | 52 | 0.1 | 0.2 |
| 22 | 53 | 0.1 | 0.2 |

The above table shows that the holographic information medium of the invention indicates an excellent result wherein there is no sensitivity decline for regeneration.

(Recording on holographic recording medium and evaluation 6)

On the holographic recording media which were prepared in the aforesaid way, a series of multiple holograms were written in accordance with procedures described in U. S. Patent No. 5,719,691, and sensitivity (recording energy), shrinkage resistance and contrast of refractive index were measured and evaluated in accordance with the following method, and the results thereof thus obtained are shown in Table 13.

(Measurement of sensitivity)

A digital pattern was displayed, by a holographic manufacturing apparatus equipped with Nd: YAG laser (532 nm), on a holographic recording medium, under the safelight, and a hologram was obtained by giving holographic exposure of the digital pattern with energy of 0.1 - 30 mJ/cm$^2$. Then, the holographic recording medium was heated and processed for 5 minutes at 100°C after being processed for 5 minutes under a sunshine fade meter of 70000 lux. With respect to this processed recording medium, regenerated light was read by CCD by using the Nd: YAG laser (532 nm) as reference light under the safelight, and minimum exposure amount by which an excellent digital pattern was regenerated was measured as sensitivity (S1).

(Evaluation of shrinkage resistance)

A shrinkage resistance is expressed by a rate of shrinkage obtained by measurement in the following method.

Fig. 1 is a schematic diagram showing a principle of a measuring instrument for measuring the rate of shrinkage. Namely, 01 represents a light emission point of the white light illumination light source that illuminates hologram 3, and 02 represents a point of view of an observer. In the measuring instrument, white light illumination light source 4 is provided at light emission point 01, and spectroscope 5 is provided at point of view 02. The spectroscope 5 is connected to personal computer 6, and on the top face of hologram 3 that measures luminance distribution of spectral wavelength, there is provided movable pinhole plate 7 on which pinhole 8 that makes light to pass through partially is made. The movable pinhole plate 7 is of the structure to be mounted on an unillustrated XY stage to be capable of moving to any position.

Namely, when the movable pinhole plate 7 is at point P (I, J), θc represents an angle between the center of the pinhole 8 and white light illumination light source 4, and θi represents an angle with the spectroscope 5. In the area of point P (I, J) of hologram 3, illumination light 9 is made to illuminate from angle θc, and regenerated light 11 is emitted in the direction of θi. The regenerated light 11 is subjected to spectral diffraction by the spectroscope 5, and a wavelength

that makes luminance to be the peak is regenerated wavelength $\lambda c$ at P (I, J). This relationship is used to measure $\theta c$, $\theta i$ and $\lambda c$ at respective points of hologram 3, while moving the movable pinhole plate 7.

When a rate of shrinkage of hologram at point P (I, J) is represented by M (I, J), rate of shrinkage M (I, J) of hologram can be expressed by the following expression, when nr represents an average refractive index of photo-image recording material before recording and nc represents an average refractive index of hologram after photographic processing.

$$M(I, J) = -nc/nr \cdot \lambda r/\lambda c \cdot (\cos\theta c - \cos\theta i)/(\cos\theta o - \cos\theta r)$$

Incidentally, $\theta o$ in the above expression represents an angle of incidence to holographic recording medium, $\lambda r$ represents a wavelength of a laser beam, and $\theta r$ represents an angle of incidence of a reference light to holographic recording medium.

(Evaluation of contrast of refractive index)

The contrast of the refractive index was obtained from the diffraction efficiency measured in accordance with the following method. For the measurement of the diffraction efficiency, a spectrophotometer of an ART 25C type made by JASCO Co. was used, and a photo-multi-meter having a slit with a width of 3 mm was provided on the circumference whose radius is 20 cm and has on its center a sample. Monochromatic light with a width of 0.3 mm was made to enter at an angle of 45° to the sample, and light diffracted from the sample was detected. The ratio of the greatest value of those other than regular reflected light to the value in the case of receiving incident light directly without placing a sample is made to be diffraction efficiency, and contrast of the diffractive index ($\Delta n$) was obtained from diffraction efficiency of the hologram obtained.

Table 13

| Holographic recording medium No. | S [mJ/cm$^2$] | Rate of shrinkage | $\Delta n$ (x10^-3) | |
|---|---|---|---|---|
| 23 | 3.0 | 0.4 | 6.2 | Comp. |
| 24 | 2.2 | 0.1 | 6.7 | Inv. |
| 25 | 2.3 | 0.1 | 6.5 | Inv. |
| 26 | 2.4 | 0.1 | 6.8 | Inv. |
| 27 | 2.5 | 0.1 | 6.4 | Inv. |
| 28 | 2.4 | 0.1 | 6.5 | Inv. |
| 29 | 2.5 | 0.1 | 6.4 | Inv. |
| 30 | 2.2 | 0.1 | 6.6 | Inv. |
| 31 | 2.3 | 0.1 | 6.7 | Inv. |
| 32 | 2.1 | 0.1 | 6.9 | Inv. |
| 33 | 2.1 | 0.1 | 6.9 | Inv. |
| 34 | 2.2 | 0.1 | 6.9 | Inv. |
| 35 | 2.1 | 0.1 | 6.9 | Inv. |
| 36 | 2.2 | 0.1 | 6.8 | Inv. |
| 37 | 2.1 | 0.1 | 6.8 | Inv. |
| 38 | 2.2 | 0.1 | 6.8 | Inv. |
| 39 | 2.5 | 0.1 | 6.6 | Inv. |
| comp.: comparative example | | | | |

Table continued

| Inv.: The invention |
|---|

The above table shows that the recording medium of the invention has higher sensitivity, lower rate of shrinkage and higher contrast, compared with comparative examples, and indicates excellent results.

(Recording on holographic recording medium and evaluation 7)

On the holographic recording media which were prepared in the aforesaid way, a series of multiple holograms were written in accordance with procedures described in TOKKAI No. 2002-123949, and sensitivity (recording energy) was measured and evaluated in accordance with the following method, and the results obtained are shown in Table 14.

(Measurement of sensitivity)

A digital pattern was displayed, by a holographic manufacturing apparatus equipped with Nd: YAG laser (532 nm), on a holographic recording medium, under the safelight, and a hologram was obtained by giving holographic exposure of the digital pattern with energy of 0.1 - 30 mJ/cm$^2$. Then, the holographic recording medium was heated and processed for 5 minutes at 100°C after being processed for 5 minutes under a sunshine fade meter of 70000 lux. With respect to this processed recording medium, regenerated light was read by CCD by using the Nd: YAG laser (532 nm) as reference light under the safelight, and minimum exposure amount by which an excellent digital pattern was regenerated was measured as sensitivity (S1).

Table 14

| Holographic recording medium No. | S [Mj/CM$^2$] | |
|---|---|---|
| 55 | 2.9 | Comp. |
| 56 | 2.0 | Inv. |
| 57 | 2.2 | Inv. |
| 58 | 1.7 | Inv. |
| 59 | 1.7 | Inv. |
| 60 | 1.8 | Inv. |
| 61 | 1.7 | Comp. |
| 62 | 1.8 | Inv. |
| 63 | 1.8 | Inv. |
| 64 | 1.9 | Inv. |
| Comp.: Comparative example<br>Inv.: The invention | | |

From the above table, the evaluation 6 is reproduced, and it is understood that the recording medium of the invention has higher sensitivity, compared with comparative examples, and shows excellent results
(0038) of the recording medium of the invention before and after preservation is higher than that in comparative examples.

(Evaluation of holographic information medium)

A holographic information medium manufactured based on Tables 13 and 14 wherein recorded information is fixed was preserved under the following conditions, then, a digital pattern was regenerated in a way suited for each information medium to be evaluated, before and after the preservation, and a difference between the minimum exposure amount with which an excellent digital pattern was regenerated before the preservation and that after the preservation was evaluated in the following method, and the results thus obtained are shown in Table 15. Further, together with the foregoing, the extent of coloring for holographic information medium was evaluated in the following method, and results obtained are shown in Table 16.

(Storage stability for heat)

A holographic information medium was preserved for two weeks at 80°C, and a difference (ΔSh) between the minimum exposure sensitivity before the preservation and that after the preservation was obtained.
Minimum exposure sensitivity difference (ΔSh) = Minimum exposure sensitivity after preservation (S2h) - Minimum exposure sensitivity before preservation (S1h)

(Storage stability for light)

After the preservation for one week at 35°C under a sunshine fade meter of 70000 lux, difference (ΔSw) between the minimum exposure sensitivity before the preservation and that after the preservation was obtained.
Minimum exposure sensitivity difference (ΔSw) = Minimum exposure sensitivity after preservation (S2w) - Minimum exposure sensitivity before preservation (S1w)

Table 15

| Holographic information medium No. | Holographic recording medium No. | ΔSh [mJ/cm$^2$] | ΔSw [mJ/cm$^2$] | |
|---|---|---|---|---|
| 23 | 23 | 0.2 | 0.3 | Comp. |
| 24 | 24 | 0.1 | 0.2 | Inv. |
| 25 | 25 | 0.1 | 0.2 | Inv. |
| 26 | 26 | 0.1 | 0.2 | Inv. |
| 27 | 27 | 0.1 | 0.2 | Inv. |
| 28 | 28 | 0.1 | 0.2 | Inv. |
| 29 | 29 | 0.1 | 0.2 | Inv. |
| 30 | 30 | 0.1 | 0.2 | Inv. |
| 31 | 31 | 0.1 | 0.2 | Inv. |
| 32 | 32 | 0.1 | 0.2 | Inv. |
| 33 | 33 | 0.1 | 0.2 | Inv. |
| 34 | 34 | 0.1 | 0.2 | Inv. |
| 35 | 35 | 0.1 | 0.2. | Inv. |
| 36 | 36 | 0.1 | 0.2 | Inv. |
| 37 | 37 | 0.1 | 0.2 | Inv. |
| 38 | 38 | 0.1 | 0.2 | Inv. |
| 39 | 39 | 0.1 | 0.2 | Inv. |
| 40 | 55 | 0.2 | 0.4 | Comp. |
| 41 | 56 | 0.1 | 0.2 | Inv. |
| 42 | 57 | 0.1 | 0.2 | Inv. |
| 43 | 58 | 0.1 | 0.2 | Inv. |
| 44 | 59 | 0.1 | 0.2 | Inv. |
| 45 | 60 | 0.1 | 0.2 | Inv. |
| 46 | 61 | 0.1 | 0.2 | Inv. |
| 47 | 62 | 0.1 | 0.2 | Inv. |
| 48 | 63 | 0.1 | 0.2 | Inv. |

Table continued

| Holographic information medium No. | Holographic recording medium No. | ΔSh [mJ/cm$^2$] | ΔSw [mJ/cm$^2$] | |
|---|---|---|---|---|
| 49 | 64 | 0.1 | 0.2 | Inv. |
| Comp.: Comparative example Inv.: The invention | | | | |

The above table shows that the holographic information medium of the invention indicates a result of excellent storage stability wherein there is no sensitivity decline for regeneration, compared with comparative examples.

(Evaluation of extent of coloring)

A holographic recording medium used in Table 5 was processed for 5 minutes under a sunshine fade meter of 70000 lux, without being subjected to holographic exposure, and then was subjected to heat treatment for 5 minutes at 100°C, to prepare a holographic information medium. Then, the holographic information medium was preserved under the following conditions, and then, the transmittance of each information medium before the preservation and that after the preservation were measured by Hitachi Spectrophotometer U-4100 made by Hitachi High-Technologies Co., and they were evaluated in the following method.

(Storage stability for heat)

A holographic information medium was preserved for two weeks at 80°C, and a difference (ΔTh) between the transmittance for 400 nm before the preservation and that after the preservation was obtained.

Transmittance difference (ΔTh) = Transmittance before preservation (T1h) - Transmittance after preservation (T2h)

(Storage stability for light)

After the preservation for one week at 35°C under a sunshine fade meter of 70000 lux, difference (ΔTh) between the transmittance for 400 nm before the preservation and that after the preservation was obtained.

Transmittance difference (ΔTw) = Transmittance before preservation (T1w) - Transmittance after preservation (T2w)

Table 16

| information medium No. | recording medium No. | ΔTh [%] | ΔTw [%] | |
|---|---|---|---|---|
| 23 | 23 | 0.6 | 0.9 | Comp. |
| 24 | 24 | 0.2 | 0.4 | Inv. |
| 25 | 25 | 0.2 | 0.4 | Inv. |
| 26 | 26 | 0.6 | 0.8 | Inv. |
| 27 | 27 | 0.3 | 0.4. | Inv. |
| 28 | 28 | 0.3 | 0.4 | Inv. |
| 29 | 29 | 0.2 | 0.4 | Inv. |

Table continued

| information medium No. | recording medium No. | ΔTh [%] | ΔTw [%] | |
|---|---|---|---|---|
| 30 | 30 | 0.3 | 0.5 | Inv. |
| 31 | 31 | 0.2 | 0.6 | Inv. |
| 32 | 32 | 0.2 | 0.4 | Inv. |
| 33 | 33 | 0.2 | 0.4 | Inv. |
| 34 | 34 | 0.2 | 0.4 | Inv. |
| 35 | 35 | 0.2 | 0.4 | Inv. |
| 36 | 36 | 0.2 | 0.5 | Inv. |
| 37 | 37 | 0.2 | 0.4 | Inv. |
| 38 | 38 | 0.2 | 0.5 | Inv. |
| 39 | 39 | 0.4 | 0.6 | Inv. |
| Comp.: Comparative example Inv.: The invention | | | | |

The above table shows that the holographic information medium of the invention indicates a result of excellent storage stability wherein there is no sensitivity decline for regeneration, compared with comparative examples.

**INDUSTRIAL APPLICABILITY**

Owing to the invention, it has become possible to obtain a holographic recording medium having high sensitivity and excellent storage stability, a holographic recording method and a holographic information medium on which information is recorded holographically.

**Claims**

**1.** A holographic recording medium provided with a holographic recording layer containing a binder forming compound, a compound provided with an ethylenical unsaturated bond, a photopolymerization initiator which can initiates a polymerization reaction of the compound provided with an ethilenical unsaturated bond, and a sensitizing dye which can spectrally sensitize a photopolymerization initiator, wherein said binder forming compound contains at least one compound combination selected from following (1) - (8):

(1) a compound provided with an isocyanate group and a compound provided with a hydroxyl group,
(2) a compound provided with an isocyanate group and a compound provided with an amino group,
(3) a compound provided with a carbodiimido group and a compound provided with a carboxyl group,
(4) a compound provided with an unsaturated ester group and a compound provided with an amino group,
(5) a compound provided with an unsaturated ester group and a compound provided with a mercaptan group,
(6) a compound provided with a vinyl group and a compound provided with a silicon hydride group,
(7) a compound provided with an oxirane group and a compound provided with a mercaptan group,
(8) a compound provided with a group selected from oxirane, oxetane, tetrahydrofuran, oxepane, monocyclic actal, bicyclic acetal, lactone, cyclic orthoester and cyclic carbonato in the molecule, and a thermal cationic polymerization initiator;

the content of said compound containing an ethylenical unsaturated compound is 1 - 50 weight% based on the whole composition; and said photopolymerization initiator includes at least a compound represented by following general formula (1).

General formula (1) $[A\text{-}Fe\text{-}B]^{+} \cdot X^{-}$

(wherein, A represents an unsubstituted or alkyl substituted cyclopentadienyl group, B represents an unsubstituted

or substituted allene group and $X^-$ represents a counter anion containing a fluorine atom.)

**2.** The holographic recording medium of claim 1, wherein the binder forming compound contains the compound combination at least one of (1) a compound provided with an isocyanate group and a compound provided with a hydroxyl group, and (7) a compound provided with an oxirane group and a compound provided with a mercaptan group.

**3.** The holographic recording medium of claim 1, wherein the binder forming compound contains the compound combination (1) a compound provided with an isocyanate group and a compound provided with a hydroxyl group, and the compound provided with an isocyanate group contains three or more isocyanate groups so as to make a content of 30 - 65 weight% in the compound.

**4.** The holographic recording medium of claim 3, wherein the compound provided with an isocyanate group contains 5 - 100 weight% of the compound containing three or more isocyanate groups so as to make a content of 30- 65 weight% in the compound.

**5.** The holographic recording medium of 3, wherein the molecular weight of the compound provided with an isocyanate group is 200 - 500.

**6.** The holographic recording medium of claim 3, wherein the compound provided with a hydroxyl group is a compound containing two or more hydroxyl groups in the molecule having a molecular weight of 100 - 2000.

**7.** The holographic recording medium of claim 1, wherein the compound provided with an ethylenic unsaturated bond includs a compound containing a (meth)acryloyl group in the molecule.

**8.** The holographic recording medium of claim 1, wherein the compound provided with an ethylenic unsaturated bond contains a compound provided with a refractive index of at least 1.55 at 50 - 100 weight% based on the whole compound provided with an ethylenic unsaturated bond.

**9.** The holographic recording medium of claim 1, wherein the holographic recording medium satisfies the relation of $0.15 \leq Dh/(D1 + D2) \leq 2.0$ ($200\ \mu m \leq Dh \leq 2.0$ mm), wherein D1 is the thickness of the first substrate, D2 is the thickness of the second substrate and Dh is the thickness of the holographic recording layer.

**10.** The holographic recording medium described in above item (1) is **characterized in that** the aforesaid first substrate is transparent and is provided with an anti-reflection treatment on the plane opposite to the plane contacting with a holographic recording layer.

**11.** The holographic recording medium of claim 1, wherein a material of the first substrate is glass.

**12.** The holographic recording medium of claim 1, wherein the second substrate is accumulated with a reflective layer having a reflectance of not less than 70%.

**13.** The holographic recording medium of claim 1, wherein the shape of the holographic recording medium is a disk-form or a card-form.

**14.** A holographic recording method for recording information on the holographic recording medium of claim 1, comprising the steps of:

reacting the binder forming compound to form a binder; holographic exposing the holographic recording medium by falling information light and reference light on the first substrate side based on the information to activate the photopolymerization initiator according to the information, and
diffusion polymerizing a compound provided with an ethylenic unsaturated bond by a activated photopolymerization initiator in a holographic recording layer.

**15.** The holographic recording method of claim 14, further comprising step of:

stabilizing the holographic recording medium by at least one of heating and light irradiation on the whole holographic recording medium after the step of diffusion polymerizing.

**16.** A holographic recording method for recording information on the holographic recording medium of claim 1, comprising the steps of:

holographic exposing the holographic recording medium by falling information light and reference light on the first substrate side based on the information to activate the photopolymerization initiator according to the information, and
diffusion polymerizing a compound provided with an ethylenic unsaturated bond by a activated photopolymerization initiator in a holographic recording layer.

**17.** A holographic information medium which the information is recorded in the holographic recording layer contained the holographic recording medium of claim 1, wherein the holographic recording layer is provided with a region comprising a binder formed from said binder forming compound and a region primarily comprising a radical polymerization product formed by radical polymerization containing an ethylenic unsaturated bond as a monomer unit formed by radical polymerization.

FIG. 1

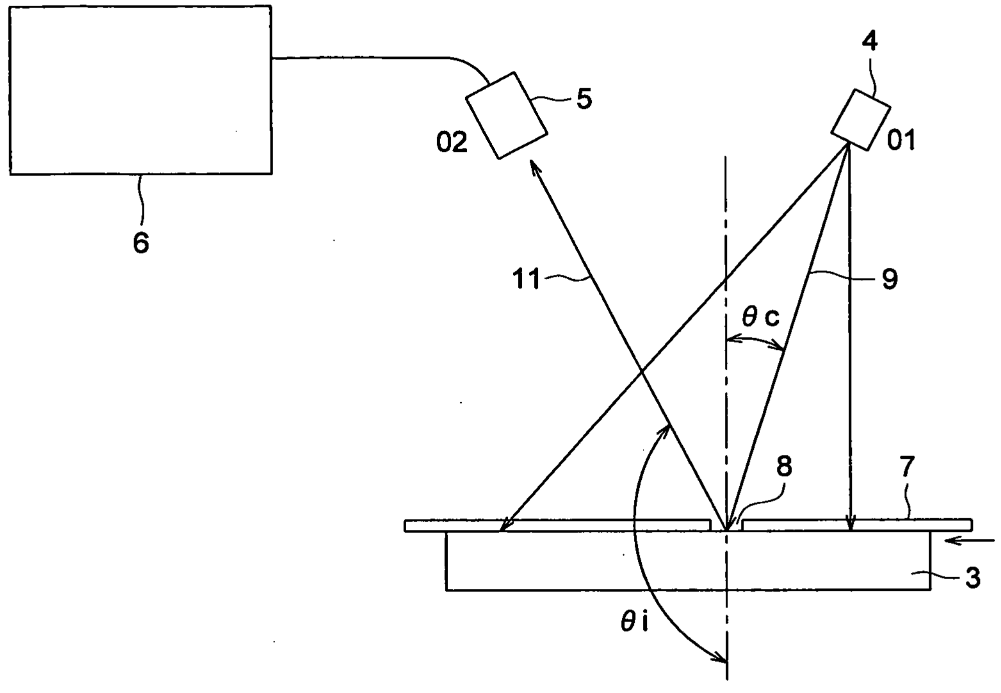

**INTERNATIONAL SEARCH REPORT**

International application No. PCT/JP2004/013591

A. CLASSIFICATION OF SUBJECT MATTER
Int.Cl[7] G03H1/02, C08G18/06

According to International Patent Classification (IPC) or to both national classification and IPC

B. FIELDS SEARCHED

Minimum documentation searched (classification system followed by classification symbols)
Int.Cl[7] G03H1/02, C08G18/06

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 11-352303 A (Lucent Technologies Inc.), 24 December, 1999 (24.12.99), Full text; all drawings & EP 945762 A1 & US 6103454 A | 1-15,17 |
| Y | JP 2003-156992 A (Dainippon Printing Co., Ltd.), 30 May, 2003 (30.05.03), Full text & US 03/87163 A1 | 1-13,16,17 |
| Y | JP 2002-149043 A (Fuji Photo Film Co., Ltd.), 22 May, 2002 (22.05.02), Full text; all drawings (Family: none) | 1-17 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>20 December, 2004 (20.12.04) | Date of mailing of the international search report<br>11 January, 2005 (11.01.05) |
| Name and mailing address of the ISA/<br>Japanese Patent Office<br>Facsimile No. | Authorized officer<br><br>Telephone No. |

Form PCT/ISA/210 (second sheet) (January 2004)

**INTERNATIONAL SEARCH REPORT**

International application No.
PCT/JP2004/013591

C (Continuation). DOCUMENTS CONSIDERED TO BE RELEVANT

| Category* | Citation of document, with indication, where appropriate, of the relevant passages | Relevant to claim No. |
|---|---|---|
| Y | JP 1-152109 A (Toray Industries, Inc.),<br>14 June, 1989 (14.06.89),<br>Full text<br>(Family: none) | 1-17 |

Form PCT/ISA/210 (continuation of second sheet) (January 2004)